# EUROPEAN PATENT APPLICATION

(11) **EP 4 451 811 A1**
(43) Date of publication of application: **23.10.2024**
(21) Application number: 22907853.0
(22) Date of filing: 09.12.2022
(51) Int. Cl.: H05K 1/02, H05K 1/18, H05K 1/11, H01L 23/12, H01L 23/538, H05K 3/46

(54) **CIRCUIT BOARD**

(30) Priority: 13.12.2021 KR 20210177934; 13.12.2021 KR 20210177974
(71) Applicant: LG INNOTEK CO., LTD., Seoul 07796 (KR)
(72) Inventor: LEE, Soo Min, Seoul 07796 (KR); SHIN, Jong Bae, Seoul 07796 (KR); JEONG, Jae Hun, Seoul 07796 (KR); JUNG, Ji Chul, Seoul 07796 (KR)
(74) Representative: Plasseraud IP
(86) International application number: PCT/KR2022/020028
(87) International publication number: WO 2023/113386

(57) **Abstract**

A circuit board according to an embodiment includes a first insulating layer; and a second insulating layer disposed on an upper surface of the first insulating layer, wherein the second insulating layer includes a cavity, and the cavity has a planar shape including a plurality of convex parts convex toward an inner direction of the second insulating layer.

## Description

### [Technical Field]

An embodiment relates to a circuit board and a semiconductor package including the same.

### [Background Art]

Recently, in order to meet a demand for wireless data traffic, efforts have been made to develop an improved 5G (5th generation) communication system or a pre-5G communication system.

In order to achieve a high data rate, 5G communication systems use a sub-6 GHz band, 28 GHz, 38 GHz, or higher frequencies. This high frequency band is called a mm-Wave due to a length of a wavelength.

In order to reduce a path loss of radio waves and increase a transmission distance of radio waves in a ultra-high frequency band, in the 5G communication system, integration technologies such as beamforming, massive multi-input multi-output (massive MIMO), and array antennas have been developed.

Considering that it may be composed of hundreds of active antennas of wavelengths in the frequency bands, an antenna system becomes large relatively.

Since such an antenna and AP module are patterned or mounted on the printed circuit board, low loss on the printed circuit board is very important. This means that several substrates constituting the active antenna system, that is, an antenna substrate, an antenna power feeding substrate, a transceiver substrate, and a baseband substrate, should be integrated into one compact unit.

Accordingly, a circuit board applied to a conventional 5G communication system has a structure in which a plurality of substrates are integrated, and thus has a relatively thick thickness. Accordingly, in the prior art, a thickness of the insulating layer constituting the circuit board is reduced, thereby reducing an overall thickness of the circuit board.

However, there is a limit to manufacturing a circuit board by reducing the thickness of the insulating layer, and furthermore, there is a problem that the circuit pattern is not stably protected as the thickness of the insulating layer decreases.

Accordingly, recently, an overall thickness of a device has been reduced by forming a cavity on the circuit board using a laser or sandblast and placing the device within the formed cavity.

A process of forming a general cavity essentially includes a de-smear process for removing debris from an inner wall of the cavity after forming a circuit board using a laser or sandblast. The de-smear process refers to a process of removing the inner wall of the cavity by etching.

However, when the de-smear process proceeds as described above, a size of the cavity is expanded as part of the inner wall of the cavity is removed, and this causes a problem in that the size of the cavity becomes larger than a target size.

In addition, when the size of the cavity is greater than the target size, dead regions, which are regions where circuit patterns cannot be placed, increase, and accordingly, there is a problem that the degree of circuit integration decreases or a width in a horizontal direction or a thickness in a vertical direction of the circuit board increases.

### [Disclosure]

### [Technical Problem]

An embodiment provides a circuit board capable of preventing the size of a cavity from expanding and a semiconductor package including the same.

In addition, an embodiment provides a circuit board capable of improving the inclination angle of the inner wall of the cavity and a semiconductor package including the same.

In addition, an embodiment provides a circuit board capable of improving circuit integration and a semiconductor package including the same.

In addition, an embodiment provides a circuit board with improved operating characteristics and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises a first insulating layer; and a second insulating layer disposed on an upper surface of the first insulating layer, wherein the second insulating layer includes a cavity, and the cavity has a planar shape including a plurality of convex parts convex toward an inner direction of the second insulating layer.

In addition, the circuit board further comprises a first through electrode passing through the first insulating layer; and a second through electrode passing through the second insulating layer, and wherein an inclination angle of an inner wall of the cavity corresponds to an inclination angle of a side surface of the second through electrode.

In addition, the inner wall of the cavity includes a first inner wall positioned at one side of the cavity, and a second inner wall positioned at the other side of the cavity and facing the first inner wall, wherein the second through electrode includes a first side surface positioned at one side of the second through electrode, and a second side surface positioned at the other side of the second through electrode opposite to the first side surface, an inclination angle of the first inner wall of the cavity corresponds to an inclination angle of the first side surface of the second through electrode, and an inclination angle of the second inner wall of the cavity corresponds to an inclination angle of the second side surface of the second through electrode.

In addition, the inclination angle of the first inner wall is an internal angle between a lower surface of the cavity and the first inner wall, the inclination angle of the second inner wall is an internal angle between the lower surface of the cavity and the second inner wall, the inclination angle of the first side surface of the second through electrode is an internal angle between a lower surface of the second through electrode and the first side surface, the inclination angle of the second side surface of the second through electrode is an internal angle between the lower surface of the second through electrode and the second side surface, and the inclination angle of each of the first inner wall, the second inner wall, the first side surface, and the second side surface satisfies a range of 91 to 115 degrees.

In addition, the circuit board further comprises a metal layer disposed on at least a part of the inner wall of the cavity.

In addition, the circuit board further comprises a first circuit pattern layer disposed between an upper surface of the first insulating layer and a lower surface of the second insulating layer, and the first circuit pattern layer includes a first pad disposed in a first region of the first insulating layer vertically overlapping a lower surface of the cavity.

In addition, the first circuit pattern layer includes a second pad spaced apart from the first pad and vertically overlapping the inner wall of the cavity.

In addition, a thickness of the first pad is greater than that of the second pad.

In addition, the first circuit pattern layer includes a first metal layer disposed on an upper surface of the first insulating layer, and a second metal layer disposed on the first metal layer, the first pad includes both the first and second metal layers, and the second pad includes only the first metal layer.

In addition, the second insulating layer includes a recessed part formed at an inner wall of the cavity adjacent to an upper surface of the first insulating layer and concave in the inner direction of the second insulating layer, and at least a portion of the recessed part vertically overlaps an inner wall of the cavity.

In addition, a radius of curvature of the convex part of the cavity corresponds to a radius of curvature of an upper surface of the second through electrode.

In addition, the circuit board further comprises a third insulating layer disposed on an upper surface of the second insulating layer, and the cavity includes a first part formed in the second insulating layer and a second part formed in the third insulating layer and connected to the first part.

In addition, the inner wall of the cavity includes a first portion of the first part of the cavity, a second portion of the second part of the cavity, and a third portion of a lower surface of the third insulating layer which connects an upper end of the first portion and a lower end of the second portion and vertically overlaps the first portion.

In addition, the inner wall of the cavity has a sawtooth shape in a vertical cross section.

Meanwhile, a semiconductor package according to an embodiment comprises a first insulating layer; a second insulating layer disposed on an upper surface of the first insulating layer and including a cavity; a first circuit pattern layer including a first pad disposed between an upper surface of the first insulating layer and a lower surface of the second insulating layer and vertically overlapped with a lower surface of the cavity; a connection part disposed on the first pad of the first circuit pattern layer; and a device mounted on the connection part, and wherein the cavity has a planar including a plurality of convex parts convex toward an inner direction of the second insulating layer.

Meanwhile, a circuit board according to another embodiment comprises a first insulating layer; a second insulating layer disposed on an upper surface of the first insulating layer and including a cavity; and a shielding layer disposed on an inner wall of the second insulating layer including the cavity, and a width of an upper surface of the shielding layer at one side of the cavity is greater than a width of a lower surface of the shielding layer at the one side of the cavity.

Meanwhile, a semiconductor package according to another embodiment comprises a first insulating layer; a second insulating layer disposed on an upper surface of the first insulating layer and including a cavity; a shielding layer disposed on an inner wall of the second insulating layer including the cavity; a first circuit pattern layer including a first-first pad disposed in a first region of the upper surface of the first insulating layer that vertically overlaps the cavity and is not in contact with the second insulating layer and the shielding layer; a connection part disposed on the first-first pad of the first circuit pattern layer; and a device mounted on the connection part, the shielding layer includes a side surface exposed through the cavity, the side surface of the shielding layer has a planar shape including a plurality of convex parts toward the cavity, and a width of an upper surface of the shielding layer at one side of the cavity is greater than a width of a lower surface of the shielding layer at the one side of the cavity.

### [Advantageous Effects]

The circuit board of the embodiment includes at least one insulating layer in which a cavity is formed. The cavity may be formed by forming a part of the cavity in a state in which a dummy electrode is formed, and thus removing the dummy electrode exposed through a part of the cavity by etching. Accordingly, the embodiment does not require a de-smear process required in the comparative example. In addition, the embodiment can solve the problem of expanding the size of the cavity by not proceeding with the de-smear process. Accordingly, the embodiment may form a cavity having substantially the same size as the target size, and accordingly, circuit integration may be improved.

In addition, the embodiment may prevent the expansion of the size of the cavity, thereby minimizing a dead region caused by the expansion of the cavity. Accordingly, an embodiment may minimize a width in a horizontal direction and a thickness in a vertical direction of the circuit board by minimizing the dead region. Accordingly, an embodiment may make the circuit board and the semiconductor package slim.

In addition, an embodiment forms a final cavity through an etching of the dummy electrode in a state in which the dummy electrode is formed. Accordingly, when the insulating layer in which the cavity is formed is made of an insulating material including glass fibers, it is possible to solve the problem that the glass fiber is exposed through the cavity. In a comparative example, there is a problem that a glass fiber is exposed through the cavity, and operating characteristics of an device disposed in the cavity may deteriorate according to the exposure of the glass fiber. In contrast, the embodiment forms a cavity with the dummy electrode disposed, thereby preventing the glass fiber from penetrating the dummy electrode and protruding into the cavity. Accordingly, the embodiment may have a structure in which the glass fiber does not protrude into the cavity even after the dummy electrode is removed by etching. Accordingly, the embodiment may further improve product reliability of a circuit board.

In addition, a shielding layer may be provided on an inner wall of the insulating layer including the cavity. The shielding layer has a width smaller than that of a through electrode passing through the insulating layer. Furthermore, a width of an upper surface of the shielding layer is greater than that of a lower surface. Accordingly, according to an embodiment, signal interference between a region in which the cavity is formed and other regions may be minimized by using the shielding layer, and thus operating characteristics may be improved.

Furthermore, in an embodiment, a heat transfer path may be formed in a direction toward an outside of the circuit board by allowing a width of an upper surface of the shielding layer to be greater than a width of a lower surface thereof. For example, a device may be disposed in the cavity of the embodiment, and heat may be generated by the device. In this case, in an embodiment, heat generated from the device may be transferred to the outside of the circuit board by using the shielding layer, thereby improving heat dissipation characteristics of the circuit board.

In addition, a concave part that is concave toward the lower surface of the shielding layer is formed at an upper surface of the shielding layer in the embodiment. The convex part may expose at least a portion of an inner wall of the insulating layer including the cavity. In this case, a semiconductor package may be manufactured by forming a molding layer molding the cavity in a state in which the device is mounted in the cavity. In this case, the molding layer has a higher adhesion to a dielectric layer than that to the metal layer. Accordingly, in an embodiment, at least a portion of the molding layer fills the convex part of the shielding layer and makes contact with at least a portion of the inner wall of the insulating layer including the cavity. Accordingly, an embodiment may improve adhesion between the insulating layer and the molding layer.

In addition, the first circuit pattern layer of the embodiment includes a first-first pad disposed in a region vertically overlapping a first region R1 of the upper surface of the first insulating layer and a first-second pad disposed in a region vertically overlapping a second region. In the embodiment, a shielding layer is not disposed on at least a portion of the inner wall of the second insulating layer including the cavity. In this case, in the embodiment, traces connecting the first-first pad and the first-second pad directly to each other are disposed in a region in which the shielding layer is not disposed. Accordingly, the embodiment may reduce a signal path length between the first-first pad and the first-second pad compared to the comparative example, thereby minimizing signal loss caused by an increase in the signal path. In addition, in the embodiment, circuit integration of the circuit board may be improved by arranging traces directly connecting the first-first pad and the first-second pad, thereby reducing an overall volume of the circuit board.

### [Description of Drawings]

FIG. 1 is a cross-sectional view of a circuit board according to a first embodiment.
FIG. 2 is a plan view omitting some components of the circuit board according to the first embodiment.
FIG. 3 is a view showing a circuit board according to a second embodiment.
FIG. 4 is a view showing a detailed layer structure of a portion of the circuit board of FIG. 3.
FIG. 5 is a view showing a circuit board according to a third embodiment.
FIG. 6 is a view showing a circuit board according to a fourth embodiment.
FIG. 7 is a view showing a circuit board according to a fifth embodiment.
FIG. 8 is a view showing a circuit board according to a sixth embodiment.
FIG. 9 is a plan view omitting some components of the circuit board according to the sixth embodiment of FIG. 8.
FIG. 10 is a view showing a circuit board according to a seventh embodiment.
FIG. 11 is a view showing a circuit board according to an eighth embodiment.
FIG. 12 is a view showing a circuit board according to a ninth embodiment.
FIG. 13 is a view showing a detailed layer structure of a portion of the circuit board of FIG. 12.
FIG. 14 is a view showing a first modified example of the third pad of FIG. 12.
FIG. 15 is a view showing a second modified example of the third pad of FIG. 12.
FIG. 16 is a view showing a circuit board according to a tenth embodiment.
FIG. 17 is a plan view omitting some components of the circuit board of FIG. 16.
FIG. 18 is a view showing a semiconductor package according to an embodiment.
FIGS. 19 to 26 are views showing a method of manufacturing the circuit board shown in FIG. 3 in order of processes.

### [Best Mode]

Hereinafter, embodiments of the present disclosure will be described in detail with reference to the accompanying drawings.

However, the spirit and scope of the present disclosure is not limited to a part of the embodiments described, and may be implemented in various other forms, and within the spirit and scope of the present disclosure, one or more of the elements of the embodiments may be selectively combined and replaced.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

### -Electronic device-

Before describing an embodiment, a semiconductor package having a structure in which a chip is mounted on a circuit board according to an embodiment may be included in an electronic device.

In this case, an electronic device includes a main board (not shown). The main board may be physically and/or electrically connected to various components. For example, the main board may be connected to the semiconductor package of the embodiment. Various semiconductor devices may be mounted on the semiconductor package. For example, the semiconductor package may include memory chips such as volatile memory (e.g., DRAM), non-volatile memory (e.g., ROM), flash memory, and application processor chips such as central processors (e.g., CPUs), graphics processors (e.g., GPUs), digital signal processors, encryption processors, microprocessors, and microcontrollers, and logic chips such as analog-digital converters and application-specific ICs (ASICs).

In addition, the embodiment provides a semiconductor package capable of mounting two or more chips of different types on one substrate while reducing the thickness of the semiconductor package connected to the main board of the electronic device.

In this case, the electronic device may include a smart phone, a personal digital assistant, a digital video camera, a digital still camera, a network system, a computer, a monitor, a tablet, a laptop, a netbook, a television, a video game, a smart watch, an automotive, and the like. However, the embodiment is not limited thereto, and may be any other electronic device that processes data in addition to these.

Hereinafter, a circuit board and a package board including the same according to an embodiment will be described.

### - Circuit board -

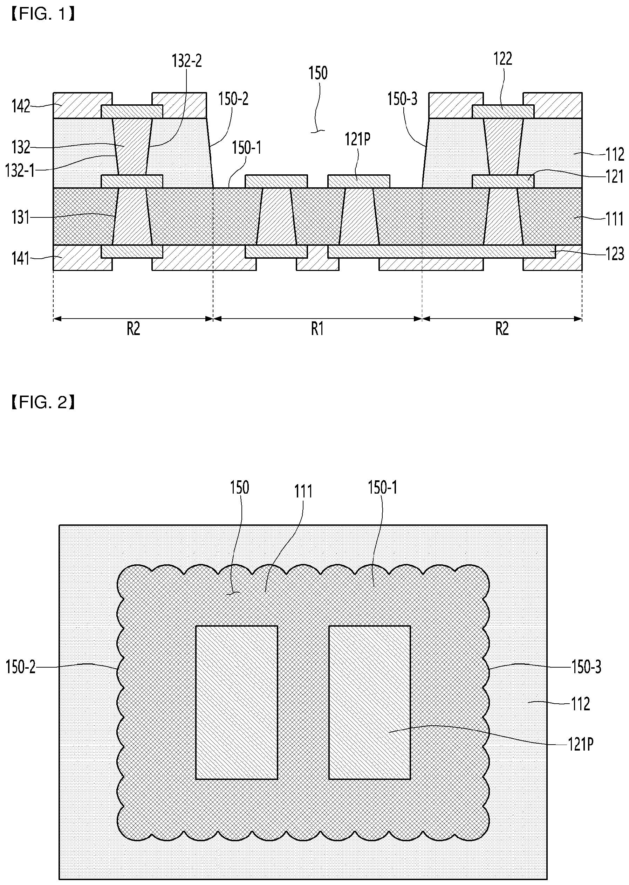

FIG. 1 is a cross-sectional view of a circuit board according to a first embodiment, and FIG. 2 is a plan view omitting some components of the circuit board according to the first embodiment.

The circuit board according to an embodiment includes a first insulating layer 111, a second insulating layer 112, a first circuit pattern layer 121, a second circuit pattern layer 122, a third circuit pattern layer 123, a first through electrode 131, a second through electrode 132, a first protective layer 141, and a second protective layer 142.

At least one of the first insulating layer 111 and the second insulating layer 112 may be rigid or flexible. For example, at least one of the first insulating layer 111 and the second insulating layer 112 may include glass or plastic. In detail, at least one of the first insulating layer 111 and the second insulating layer 112 may include chemical strengthened glass/heat strengthened glass such as soda lime glass or aluminosilicate glass, or reinforced or soft plastic such as polyimide (PI), polyethylene terephthalate (PET), propylene glycol (PPG) polycarbonate (PC), or sapphire.

In addition at least one of the first insulating layer 111 and the second insulating layer 112 may include a photo-isotropic film. For example, at least one of the first insulating layer 111 and the second insulating layer 112 may include a cyclic olefin copolymer (COC), a cyclic olefin polymer (COP), a photo-isotropic polycarbonate (PC), a photo-isotropic polymethyl methacrylate (PMMA), or the like.

In addition, at least one of the first insulating layer 111 and the second insulating layer 112 may be formed of a material including an inorganic filler and an insulating resin. For example, a material constituting the first insulating layer 111 and the second insulating layer 112 may include a reinforcing material such as an inorganic filler such as silica or alumina together with a thermosetting resin such as an epoxy resin or a thermoplastic resin such as polyimide, and specifically, may be an ABF (Ajinomoto Build-up Film), FR-4, Bismaleimide Triazine (BT), Photo Imageable Dielectric Resin (PID), BT, etc.

In addition, at least one of the first insulating layer 111 and the second insulating layer 112 may be partially bent having a curved surface. That is, at least one of the first insulating layer 111 and the second insulating layer 112 may partially have a plane and may partially be bent having a curved surface. Specifically, at least one of the first insulating layer 111 and the second insulating layer 112 may be bent while having a curved end or may be bent or bent with a surface including a random curvature.

The first insulating layer 111 and the second insulating layer 112 may include the same insulating material, and differently, may include different insulating materials. For example, the first circuit pattern layer 121 may include a prepreg, and the second insulating layer 112 may be a resin coated copper (RCC).

Each thickness of the first insulating layer 111 and the second insulating layer 112 may satisfy a range of 10 µm to 60 µm. For example, each thickness of the first insulating layer 111 and the second insulating layer 112 may satisfy a range of 12 µm to 45 µm. For example, each thickness of the first insulating layer 111 and the second insulating layer 112 may satisfy a range of 15 µm to 30 µm.

However, although the first insulating layer 111 and the second insulating layer 112 are shown to have the same thickness, the embodiment is not limited thereto. For example, the first insulating layer 111 and the second insulating layer 112 may have different thicknesses.

For example, the first insulating layer 111 may satisfy a range of 10 µm to 60 µm. The second insulating layer 112 may have a thickness smaller or greater than a thickness of the first insulating layer 111 within a range of 10 µm to 60 µm.

Each thickness of the first insulating layer 111 and the second insulating layer 112 may mean a vertical distance between circuit layers adjacent to each other in a thickness direction. For example, the thickness of the first insulating layer 111 may mean a vertical distance between a lower surface of the first circuit pattern layer 121 and an upper surface of the third circuit pattern layer 123. For example, the thickness of the second insulating layer 112 may mean a vertical distance between an upper surface of the first circuit pattern layer 121 and a lower surface of the second circuit pattern layer 122.

If the thickness of each of the first insulating layer 111 and the second insulating layer 112 is less than 10 µm, a distance between adjacent circuit layers in a thickness direction may be reduced, and thus operation characteristics may be deteriorated due to signal interference therebetween. In addition, if the thicknesses of the first insulating layer 111 and the second insulating layer 112 exceed 60 µm, an overall thickness of the circuit board may increase. In addition, if the thickness of each of the first insulating layer 111 and the second insulating layer 112 exceeds 60 µm, a thickness of a through electrode may correspondingly increase, and accordingly, a signal transmission distance may increase, thereby increasing signal transmission loss.

Meanwhile, the second insulating layer 112 may include a cavity 150. The cavity 150 may pass through the second insulating layer 112. However, the embodiment is not limited thereto, and the cavity 150 may not pass through the second insulating layer 112. However, if the cavity 150 does not pass through the second insulating layer 112, a lower surface 150-1 of the cavity 150 may be positioned lower than an upper surface of the first circuit pattern layer 121. That is, when the cavity 150 is formed by adjusting a laser processing condition in a state in which a stopper layer is not formed, a lower surface 150-1 of the cavity 150 may be positioned between an upper surface (or a lower surface of the first circuit pattern layer) of the first insulating layer 111 and an upper surface of the first circuit pattern layer 121. For example, if the cavity 150 is formed in a structure that does not pass through the second insulating layer 112 in an absence of the stopper layer, the laser processing condition may be adjusted such that the lower surface 150-1 of the cavity 150 is positioned between the upper surface of the first insulating layer 111 and the upper surface of the first circuit pattern layer 121. However, hereinafter, it will be described that the cavity 150 is formed to pass through the second insulating layer 112.

When the cavity 150 passes through the second insulating layer 112, the lower surface 150-1 of the cavity 150 may be an upper surface of the first insulating layer 111 at a region vertically overlapping the cavity 150.

An inner wall of the cavity 150 may have a predetermined inclination. For example, the inner wall of the cavity 150 may include a first inner wall 150-2 and a second inner wall 150-3. The first inner wall 150-2 of the cavity 150 may mean an inclined surface of one side of the cavity 150 in a vertical cross section of the cavity 150. In addition, the second inner wall 150-3 of the cavity 150 may mean an inclined surface of the other side opposite to the one side of the cavity 150 in the vertical cross section of the cavity 150. For example, the first inner wall 150-2 and the second inner wall 150-3 of the cavity 150 may face each other in the vertical cross section of the cavity 150.

The first inner wall 150-2 of the cavity 150 may have an inclination inclined in a first direction such that the width decreases from the upper surface of the second insulating layer 112 toward the lower surface of the second insulating layer 112. In addition, the second inner wall 150-3 of the cavity 150 may have an inclination inclined in a second direction different from the first direction so that the width decreases from the upper surface of the second insulating layer 112 toward the lower surface of the second insulating layer 112. The first direction in which the first inner wall 150-2 of the cavity 150 is inclined may mean a symmetrical direction in the second direction in which the second inner wall 150-3 is inclined.

An inclination angle of the first inner wall 150-2 of the cavity 150 may be close to 90 degrees. The inclination angle of the first inner wall 150-2 of the cavity 150 may mean an internal angle between the lower surface 150-1 of the cavity 150 and the first inner wall 150-2 of the cavity 150. The inclination angle of the first inner wall 150-2 of the cavity 150 may satisfy a range of 91 to 115 degrees. The inclination angle of the first inner wall 150-2 of the cavity 150 may satisfy a range of 93 to 112 degrees. The inclination angle of the first inner wall 150-2 of the cavity 150 may satisfy a range of 95 to 110 degrees. If the inclination angle of the first inner wall 150-2 of the cavity 150 is less than 91 degrees, the inclination angle of the first inner wall 150-2 may have an acute angle according to processing conditions of the cavity 150, and thus processability may be deteriorated in a process of mounting a device in the cavity 150. In addition, when the inclination angle of the first inner wall 150-2 of the cavity 150 is less than 91 degrees, a problem may occur in which a position of the device is distorted in a process of mounting the device in the cavity 150, and as a result, mounting characteristics of the device may be deteriorated. In addition, if the inclination angle of the first inner wall 150-2 of the cavity 150 exceeds 115 degrees,
a difference between an upper width of the cavity 150 (e.g., a region adjacent to the upper surface of the second insulating layer 112 among an entire region in a thickness direction of the cavity 150) and a lower width of the cavity 150 (e.g., a region adjacent to the lower surface of the second insulating layer 112 among the entire region in the thickness direction of the cavity 150) may increase. If the difference between the lower width and the upper width of the cavity 150 increases, an area of a dead region in which the circuit pattern is not disposed increases, and accordingly, the circuit integration may decrease or an overall volume of the circuit board may increase.

Meanwhile, an inclination angle of the second inner wall 150-3 of the cavity 150 may be close to 90 degrees. The inclination angle of the second inner wall 150-3 of the cavity 150 may mean an internal angle between the lower surface 150-1 of the cavity 150 and the second inner wall 150-3. The inclination angle of the second inner wall 150-3 of the cavity 150 may correspond to the inclination angle of the first inner wall 150-2 of the cavity 150. Here, corresponding to the inclination angle may mean that the difference between the inclination angle of the first inner wall 150-2 and the inclination angle of the second inner wall 150-3 is 10 degrees or less, 8 degrees or less, 5 degrees or less, or 2 degrees or less.

Accordingly, the inclination angle of the second inner wall 150-3 of the cavity 150 may satisfy a range between 91 and 115 degrees, a range between 93 and 112 degrees, or a range between 95 and 110 degrees.

In this case, the inclination angle of the first inner wall 150-2 and the second inner wall 150-3 of the cavity 150 may correspond to an inclination angle of a side surface of a second through electrode 132 to be described later. Corresponding to the inclination angle of the side surface may mean that a difference between the inclination angle of the side surface of the second through electrode 132 and the inclination angle of the inner wall of the cavity 150 is 5 degrees or less, 3 degrees or less, or 2 degrees or less. The meaning corresponding to the inclination angle of the side surface may mean that a difference between the inclination angle of the side surface of the second through electrode 132 and the inclination angle of the inner wall of the cavity 150 is 5 degrees or less, 3 degrees or less, or 2 degrees or less.

For example, the inner wall of the cavity 150 may have an inclination angle corresponding to an inclination angle of a side surface of a dummy electrode (described later) formed under the same condition as a condition of the second through electrode 132. In this case, when the second through electrode 132 is manufactured, the dummy electrode is formed together with the second through electrode 132 under substantially the same conditions as process conditions of the second through electrode 132. Accordingly, the inclination angle of the inner wall of the cavity 150 may correspond to an inclination angle of a side surface of a second through electrode 132.

An inclination angle of the inner wall of the cavity 150 and a shape thereof will be described in more detail below.

A circuit pattern layer may be disposed on surfaces of the first insulating layer 111 and the second insulating layer 112.

For example, a first circuit pattern layer 121 may be disposed between an upper surface of the first insulating layer 111 and a lower surface of the second insulating layer 112. For example, the first circuit pattern layer 121 may be disposed on the upper surface of the first insulating layer 111.

In addition, a second circuit pattern layer 122 may be disposed at an upper surface of the second insulating layer 112. For example, the second circuit pattern layer 122 may be disposed on the upper surface of the second insulating layer 112.

In addition, a third circuit pattern layer 123 may be disposed at a lower surface of the first insulating layer 111. For example, the third circuit pattern layer 123 may be disposed under the lower surface of the first insulating layer 111.

The first circuit pattern layer 121, the second circuit pattern layer 122, and the third circuit pattern layer 123 are wires that transmit electrical signals and may be formed of a metal material having high electrical conductivity. To this end, the first circuit pattern layer 121, the second circuit pattern layer 122, and the third circuit pattern layer 123 may be formed of at least one metal material selected from gold (Au), silver (Ag), platinum (Pt), titanium (Ti), tin (Sn), copper (Cu), and zinc (Zn). In addition, the first circuit pattern layer 121, the second circuit pattern layer 122, and the third circuit pattern layer 123 may be formed of a paste or a solder paste including at least one metal material selected from among gold (Au), silver (Ag), platinum (Pt), titanium (Ti), tin (Sn), copper (Cu), and zinc (Zn), which have excellent bonding strength. Preferably, the first circuit pattern layer 121, the second circuit pattern layer 122, and the third circuit pattern layer 123 may be formed of copper (Cu) which has high electrical conductivity and is relatively inexpensive.

Each of the first circuit pattern layer 121, the second circuit pattern layer 122, and the third circuit pattern layer 123 may have a thickness in a range of 5 µm to 50 µm. For example, each of the first circuit pattern layer 121, the second circuit pattern layer 122, and the third circuit pattern layer 123 may have a thickness in a range of 10 µm to 40 µm. For example, each of the first circuit pattern layer 121, the second circuit pattern layer 122, and the third circuit pattern layer 123 may have a thickness in a range of 15 µm to 30 µm. If the thicknesses of the first circuit pattern layer 121, the second circuit pattern layer 122, and the third circuit pattern layer 123 are less than 5 µm, the resistance of the circuit pattern increases, and thus the signal transmission loss may increase. If the thicknesses of the first circuit pattern layer 121, the second circuit pattern layer 122, and the third circuit pattern layer 123 are less than 5µm, there may be a problem in communication performance, such as a decrease in the allowable current of a signal that may be transmitted to the corresponding circuit pattern layer, and a decrease in the signal transmission speed. In addition, if the thicknesses of the first circuit pattern layer 121, the second circuit pattern layer 122, and the third circuit pattern layer 123 exceed 50 µm, a line width of the corresponding circuit pattern increases, and accordingly, it may be difficult to refine the circuit pattern. In addition, if the thicknesses of the first circuit pattern layer 121, the second circuit pattern layer 122, and the third circuit pattern layer 123 exceed 50 µm, the thickness of the circuit board may increase correspondingly.

The first circuit pattern layer 121, the second circuit pattern layer 122, and the third circuit pattern layer 123 may be formed by an Additive process, a Subtractive process, a MSAP (Modified Semi Additive Process), and a Semi Additive Process (SAP) method, which are typical manufacturing processes of a printed circuit board, and a detailed description thereof will be omitted. In addition, the first circuit pattern layer 121, the second circuit pattern layer 122, and the third circuit pattern layer 123 may have different layer structures according to a manufacturing method. For example, each of the first circuit pattern layer 121, the second circuit pattern layer 122, and the third circuit pattern layer 123 may have a three-layer structure as manufactured by an MSAP method. As another example, the first circuit pattern layer 121, the second circuit pattern layer 122, and the third circuit pattern layer 123 may have a two-layer structure as manufactured by an SAP method. This will be described below.

Meanwhile, the first circuit pattern layer 121, the second circuit pattern layer 122, and the third circuit pattern layer 123 each include a trace and a pad.

The trace refers to a wiring in a form of a long line that transmits an electrical signal. The pad may be a mounting pad on which components such as chips are mounted, a core pad or a BGA pad for connection with an external board, or a through electrode pad connected to a through electrode.

In particular, the first circuit pattern layer 121 may include a pad 121P. The pad 121P may mean a mounting pad on which a device is mounted later.

Specifically, an upper surface of the first insulating layer 111 includes a first region R1 which vertically overlaps the cavity 150 and does not contact the second insulating layer 112. In addition, the upper surface of the first insulating layer 111 may include a second region R2 which contacts the second insulating layer 112. The second region R2 of the upper surface of the first insulating layer 111 may mean a region which does not vertically overlap the lower surface 150-1 of the cavity 150. However, in the second region R2 of the upper surface of the first insulating layer 111, a portion adjacent to the first region R1 may be perpendicular to the first and second inner walls 150-2 and 150-3 of the cavity 150.

The pad 121P may be disposed in the first region R1 of the first insulating layer 111 in the first circuit pattern layer 121. The pad 121P vertically overlaps the cavity 150, and thus an upper surface of the pad 121P may be exposed through the cavity 150. Accordingly, the pad 121P may function as a mounting pad connected to a device when the device is mounted in the cavity 150.

A first protective layer 141 may be disposed on a lower surface of the first insulating layer 111.

The first protective layer 141 may include an opening (not shown) exposing at least a portion of a lower surface of the third circuit pattern layer 123 while vertically overlapping a lower surface of the third circuit pattern layer 123.

In addition, a second protective layer 142 may be disposed on an upper surface of the second insulating layer 112. The second protective layer 142 may include an opening (not shown) exposing at least a portion of the upper surface of the third circuit pattern layer 123 while vertically overlapping the upper surface of the first circuit pattern layer 121.

The first protective layer 141 and the second protective layer 142 may be resist layers. For example, the first protective layer 141 and the second protective layer 142 may be solder resist layers including an organic polymer material. For example, the first protective layer 141 and the second protective layer 142 may include an epoxy acrylate-based resin. Specifically, the first protective layer 141 and the second protective layer 142 may include a resin, a curing agent, a photo initiator, a pigment, a solvent, a filler, an additive, an acrylic-based monomer, and the like. However, the embodiment is not limited thereto, and the first protective layer 141 and the second protective layer 142 may be any one of a photo solder resist layer, a cover-lay, and a polymer material.

The first protective layer 141 and the second protective layer 142 may have a thickness of about 1 µm to about 20 µm. The first protective layer 141 and the second protective layer 142 may have a thickness of about 1 µm to about 15 µm. For example, the first protective layer 141 and the second protective layer 142 may have a thickness of about 5 µm to about 20 µm. If the thicknesses of the first protective layer 141 and the second protective layer 142 are greater than about 20 µm, the thickness of the circuit board may increase. If the thicknesses of the first protective layer 141 and the second protective layer 142 are less than about 1 µm, electrical reliability or physical reliability may be deteriorated because circuit pattern layers included in the circuit board are not stably protected.

Meanwhile, the circuit board of the embodiment includes a through electrode. The through electrode may electrically connect circuit pattern layers disposed on different layers.

For example, a first through electrode 131 is disposed in the first insulating layer 111. The first through electrode 131 passes through the first insulating layer 111. The first through electrode 131 may connect the first circuit pattern layer 121 and the third circuit pattern layer 123.

For example, a second through electrode 132 is disposed in the second insulating layer 112. The second through electrode 132 may connect the first circuit pattern layer 121 and the second circuit pattern layer 122.

Meanwhile, the through electrode in an embodiment may have a plurality of layer structures. For example, the through electrodes 131 and 132 may have a two-layer structure. For example, the through electrodes 131 and 132 may have a three-layer structure. Specifically, layer structures of the through electrodes 131 and 132 may correspond to a layer structure of a circuit pattern layer connected thereto. For example, a layer structure of the first through electrode 131 may correspond to a layer structure of the first circuit pattern layer 121. In addition, a layer structure of the second through electrode 132 may correspond to a layer structure of the second circuit pattern layer 122. Here, the meaning of corresponding to the layer structure may substantially mean that the layers of each configuration are composed of one layer connected to each other. For example, the first circuit pattern layer 121 includes a seed layer and a metal layer, and the first through electrode 131 may include a seed layer corresponding to the seed layer of the first circuit pattern layer 121 and a metal layer corresponding to the metal layer of the first circuit pattern layer 121.

Hereinafter, the cavity 150 formed in the second insulating layer 112 will be described in detail.

The inner wall of the cavity 150 in an embodiment may have an ignition angle and surface roughness different from those of the comparative example. For example, in the comparative example, a first cavity process of forming a cavity is performed by processing a region in which a cavity is to be formed with a laser, and a second cavity process is performed in which an inner wall of the cavity formed through the first cavity process is removed by a de-smear process. Accordingly, the inclination angle and surface roughness of the inner wall of the cavity in the comparative example may be determined according to the conditions of the de-smear process.

Alternatively, the embodiment forms a final cavity 150 by etching the dummy electrode exposed through the cavity 150 after forming the cavity 150 while the dummy electrode is formed. Accordingly, the embodiment does not require a de-smear process required in the comparative example. In addition, the embodiment may solve a problem of expanding the size of the cavity by not proceeding with the de-smear process. Accordingly, the embodiment may form a cavity 150 having substantially the same size as the target size, and accordingly, circuit integration may be improved.

A process of forming the cavity 150 of the present application will be briefly described as follows.

In an embodiment, when processing a through hole for forming a second through electrode 132 in the second insulating layer 112, a dummy through hole is formed in the boundary region between the first region R1 and the second region R2 of the first insulating layer 111. In addition, the embodiment performs a process of forming a dummy electrode by filling the dummy through hole with the process of forming the second through electrode 132 by filling the through hole. Accordingly, a plane of the circuit board in a state in which the dummy electrode is formed may have a structure in which the dummy electrode is disposed while surrounding the first region R1 in which the cavity 150 is to be formed.

Next, in an embodiment, a process of forming the cavity 150 may be performed by processing an inner region of the dummy electrode with a laser by using the dummy electrode as a mask pattern. In addition, when a process of forming the cavity 150 proceeds, a side surface of the dummy electrode may be exposed through the cavity 150. Next, in the embodiment, the dummy electrode exposed through the cavity 150 may be entirely removed by etching to form the final cavity 150.

Accordingly, an inner wall of the cavity 150 in an embodiment may be formed by etching the dummy electrode after the dummy electrode is formed. Specifically, the inner wall of the cavity 150 may correspond to the inner wall of the dummy through hole. For example, the inner wall of the cavity 150 may have an inclination angle corresponding to an inclination angle of an inner wall of the dummy through hole.

In addition, the inner wall of the cavity 150 may have a surface roughness corresponding to that of the side surface of the dummy electrode. In this case, in an embodiment, the final cavity 150 is formed through the etching of the dummy electrode in the state in which the dummy electrode is formed. Accordingly, when the second insulating layer 112 is formed of an insulating material including a glass fiber, it is possible to solve the problem of exposing the glass fiber through the cavity 150. For example, in a comparative example, there is a problem in that a glass fiber is exposed through the cavity, and operating characteristics of a device disposed in the cavity may deteriorate according to the exposure of the glass fiber. Unlike this, in an embodiment, the glass fiber may not protrude toward the dummy electrode in a state in which the dummy electrode is disposed, and thus, the glass fiber may not protrude through the cavity 150 even after the dummy electrode is removed by etching. Accordingly, an embodiment may further improve product reliability of a circuit board.

Accordingly, the inclination angle of the inner wall of the cavity 150 in the embodiment may correspond to the inclination angle of the side surface of the second through electrode 132 disposed in the second insulating layer 112. In this case, the fact that the inclination angle of the inner wall of the cavity 150 corresponds to the inclination angle of the side surface of the second through electrode 132 may mean that a difference between the inclination angle of the inner wall of the cavity 150 and the inclination angle of the side surface of the second through electrode 132 is 5 degrees or less, 3 degrees or less, or 2 degrees or less.

For example, the second through electrode 132 may include a first side surface 132-1 and a second side surface 132-2 in a vertical cross section.

The inclination angle of the first side surface 132-1 of the second through electrode 132 may be close to 90 degrees. The inclination angle of the first side surface 132-1 of the second through electrode 132 may mean an internal angle between a lower surface of the second through electrode 132 and the first side surface 132-1.

The inclination angle of the first side surface 132-1 of the second through electrode 132 may satisfy a range between 91 and 115 degrees. The inclination angle of the first side surface 132-1 of the second through electrode 132 may satisfy a range between 93 and 112 degrees.

Meanwhile, the inclination angle of the second side surface 132-2 of the second through electrode 132 may correspond to the inclination angle of the first side surface 132-1. The inclination angle of the second side surface 132-2 of the second through electrode 132 may have an internal angle between the lower surface of the second through electrode 132 and the second side surface 132-2. In this case, the fact that the inclination angle of the second side surface 132-2 of the second through electrode 132 corresponds to the inclination angle of the first side surface 132-1 may mean that a difference between the inclination angle of the first side surface 132-1 and the inclination angle of the second side surface 132-2 is 10 degrees or less, 8 degrees or less, 5 degrees or less, or 2 degrees or less.

Meanwhile, the inclination of the first inner wall 150-2 of the cavity 150 may correspond to the inclination of the first side surface 132-1 of the second through electrode 132. That is, a direction in which the first inner wall 150-2 of the cavity 150 is inclined may correspond to a direction in which the first side surface 132-1 of the second through electrode 132 is inclined.

In addition, the inclination angle of the first inner wall 150-2 of the cavity 150 may correspond to the inclination angle of the first side surface 132-1 of the second through electrode 132. Here, corresponding to the inclination angle may mean that the difference between the inclination angle of the first inner wall 150-2 of the cavity 150 and the inclination angle of the first side surface 132-1 of the second through electrode 132 is 5 degrees or less, 3 degrees or less, or 2 degrees or less.

That is, the first inner wall 150-2 of the cavity 150 according to an embodiment is a portion that is in direct contact with the first side surface (not shown) of the dummy electrode having the inclination corresponding to the first side surface 132-1 of the second through electrode 132. In addition, when the dummy electrode is removed, the inclination angle of the first inner wall 150-2 of the cavity 150 may be substantially the same as the inclination angle of the first side surface of the dummy electrode. Accordingly, the inclination angle of the first inner wall 150-2 of the cavity 150 may correspond to the inclination angle of the first side surface 132-1 of the second through electrode.

Meanwhile, the inclination of the second inner wall 150-3 of the cavity 150 may correspond to the inclination of the second side surface 132-2 of the second through electrode 132. That is, a direction in which the second inner wall 150-3 of the cavity 150 is inclined may correspond to a direction in which the second side surface 132-2 of the second through electrode 132 is inclined.

The inclination angle of the second inner wall 150-3 of the cavity 150 may correspond to the inclination angle of the second side surface 132-2 of the second through electrode 132. Here, corresponding to the inclination angle may mean that a difference between the inclination angle of the second inner wall 150-3 of the cavity 150 and the inclination angle of the second side surface 132-2 of the second through electrode 132 is 5 degrees or less, 3 degrees or less, or 2 degrees or less.

That is, the second inner wall 150-3 of the cavity 150 according to an embodiment is a portion that is in direct contact with a second side (not shown) of the dummy electrode having an inclination corresponding to the second side surface 132-2 of the second through electrode 132. In addition, when the dummy electrode is removed, the inclination angle of the second inner wall 150-3 of the cavity 150 may be substantially the same as the inclination angle of the second side surface of the dummy electrode. Accordingly, the inclination angle of the second inner wall 150-3 of the cavity 150 may correspond to the inclination angle of the second side surface 132-2 of the second through electrode.

Meanwhile, the dummy electrode is formed to surround a boundary region between the first region R1 and the second region R2. Accordingly, the dummy electrode may have a structure in which a plurality of dummy electrode parts surrounding the boundary region are connected to each other.

Accordingly, as shown in FIG. 2, a planar shape of an inner wall of the cavity 150 may include a plurality of convex parts that are convex in a direction away from the cavity 150. In addition, the plurality of convex parts may have a structure connected to each other while surrounding the boundary region. In other words, the inner wall of the cavity 150 may include a convex part that is convex in a direction away from the cavity 150 or a convex part concave that is concave in the inner direction of the second insulating layer 112.

In this case, a shape of the plurality of convex parts or convex parts may correspond to a planar shape of the second through electrode 132. For example, widths of the plurality of convex parts or convex parts may correspond to a width of the second through electrode 132. Specifically, the plurality of convex parts or convex parts may have a constant radius of curvature. In this case, the radius of curvature may correspond to a beam width of a laser used in a process of forming the dummy electrode. In addition, the second through electrode 132 is also formed in the process of forming the dummy electrode, and accordingly, a beam width of a laser used to form the dummy electrode may correspond to a beam width of a laser used to form the second through electrode 132.

Accordingly, a radius of curvature of a plurality of convex parts or convex parts of the inner wall of the cavity 150 may correspond to a radius of curvature of the upper or lower surface of the second through electrode 132.

In this case, the face that the radius of curvature of a plurality of convex parts or convex parts of the inner wall of the cavity 150 corresponds to the radius of curvature of the upper or lower surface of the second through electrode 132, may mean that a difference between the radius of curvature of a plurality of convex parts or convex parts of the inner wall of the cavity 150 corresponds to the radius of curvature of the upper or lower surface of the second through electrode 132 is 10% or less, 5% or less, or 2% or less of the radius of curvature of the upper or lower surface of the second through electrode 132..

As described above, an embodiment includes a cavity 150 formed in the second insulating layer 112. And, the cavity 150 is formed in a state in which the dummy electrode is formed, and accordingly, a final cavity 150 is formed by removing the dummy electrode exposed through the cavity 150 by etching. Accordingly, an embodiment does not require a de-smear process required in the comparative example. In addition, the embodiment may solve a problem of expanding a size of the cavity by not proceeding with the de-smear process. Accordingly, an embodiment may form a cavity 150 having substantially the same size as a target size, and accordingly, circuit integration may be improved.

In addition, an embodiment forms the final cavity 150 through the etching of the dummy electrode in the state in which the dummy electrode is formed. Accordingly, when the second insulating layer 112 is made of an insulating material including glass fibers, it is possible to solve the problem that the glass fiber is exposed through the cavity 150. For example, in a comparative example, there is a problem that a glass fiber is exposed through the cavity, and operating characteristics of a device disposed in the cavity may deteriorate according to the exposure of the glass fiber. In contrast, in an embodiment, when the cavity is formed in the state in which the dummy electrode is disposed, the glass fiber cannot penetrate the dummy electrode and protrude into the cavity, and accordingly, the glass fiber may not protrude through the cavity 150 even after the dummy electrode is removed by etching. Accordingly, the embodiment may further improve the product reliability of the circuit board.

Hereinafter, another embodiment of a circuit board according to an embodiment will be described.

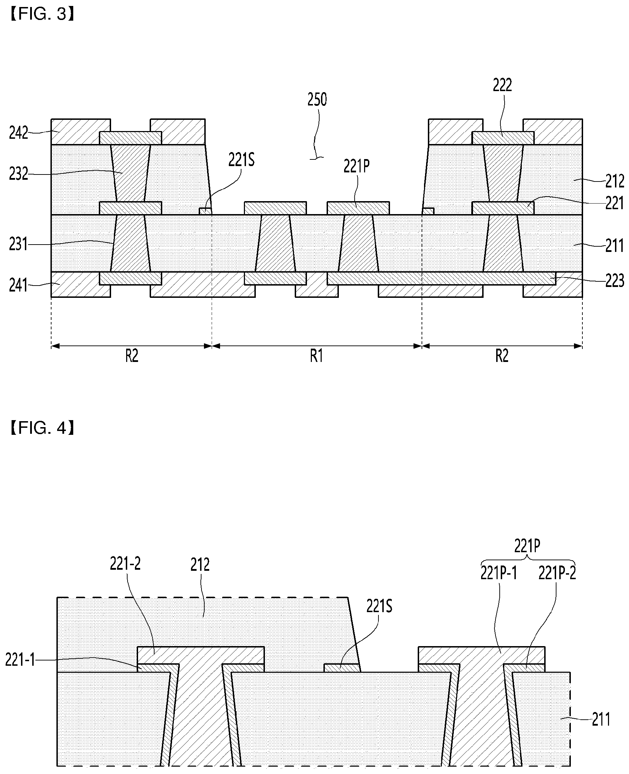

FIG. 3 is a view showing a circuit board according to a second embodiment, and FIG. 4 is a view showing a detailed layer structure of a portion of the circuit board of FIG. 3.

Referring to FIGS. 3 and 4, a circuit board includes a first insulating layer 211, a second insulating layer 212, a first circuit pattern layer 221, a second circuit pattern layer 222, a third circuit pattern layer 223, a first through electrode 231, a second through electrode 232, a first protective layer 241, and a second protective layer 242.

In this case, an overall structure of a circuit board of a second embodiment corresponds to the structure of the circuit board of FIG. 1, and accordingly, a detailed description thereof will be omitted for a configuration having substantially the same structure.

Each of the first circuit pattern layer 221, the second circuit pattern layer 222, the third circuit pattern layer 223, the first through electrode 231, and the second through electrode 132 in an embodiment may have a plurality of layer structures.

For example, the first circuit pattern layer 221, the second circuit pattern layer 222, the third circuit pattern layer 223, the first through electrode 231, and the second through electrode 232 may each have a two-layer structure or a three-layer structure. Preferably, each of the first circuit pattern layer 221, the second circuit pattern layer 222, the third circuit pattern layer 223, the first through electrode 231, and the second through electrode 232 includes a first metal layer and a second metal layer. The first metal layer may correspond to a seed layer. In addition, the second metal layer may be an electrolytic plating layer formed by electrolytic plating using the first metal layer as a seed layer.

In this case, the first circuit pattern layer 221 in an embodiment includes a first pad 221P disposed in a first region R1 of an upper surface of the first insulating layer 211. In addition, the first circuit pattern layer 221 includes a second pad 221S disposed in a boundary region of a cavity 250 of an upper surface of the first insulating layer 211.

The second pad 221S may be disposed at a region between the first region R1 and the second region R2 on the upper surface of the first insulating layer 211. Preferably, the second pad 221S may be disposed at the boundary region. In this case, the boundary region may be a portion of the second region R2. That is, the first region R1 refers to a region vertically overlapping the lower surface 150-1 of the cavity 250 in the cavity 250. Also, the boundary region does not vertically overlap the lower surface 150-1 of the cavity 250. Accordingly, the boundary region may mean a region adjacent to the first region R1 among the second region R2. For example, the boundary region may mean a region vertically overlapping the first inner wall 150-2 and the second inner wall 150-3 of the cavity 250 among the second region R2.

An upper surface of the second pad 221S may be covered with the second insulating layer 212. A side surface of the second pad 221S may not be covered with the second insulating layer 212. Preferably, a side surface of the second pad 221S may be exposed through the cavity 250.

The second pad 221S may be a part of a stopper layer used in forming the cavity 250 according to an embodiment. For example, the second pad 221S may be a part of the laser stopper layer used in forming the dummy electrode for forming the cavity 250.

That is, the second embodiment allows a dummy through hole corresponding to a dummy electrode and a cavity 250 to be formed in a boundary region of the cavity 250 using a stopper layer. At this time, depending on the laser processing conditions for forming the dummy through hole and the cavity 250, a reliability problem may occur in that the dummy through hole or the cavity 250 is partially formed in the first insulating layer 211 while penetrating the second insulating layer 212. Accordingly, the embodiment allows the dummy through hole and cavity 250 to be formed using the stopper layer, and accordingly, the dummy through hole and the cavity 250 can be formed only in the second insulating layer 212.

In addition, in an embodiment, the second insulating layer 212 corresponding to the first region R1 is processed using the stopper layer to form the cavity 250. In this case, a width of the lower surface 150-1 of the cavity 250 of an embodiment may be less than a width of the stopper layer. In this case, a width of the stopper layer may be greater than a lower width of the cavity 250 including the dummy through hole. If the stopper layer is disposed to have a width equal to the lower width of the cavity 250 including the dummy through hole, a problem may occur in which a portion of the upper surface of the first insulating layer 211 adjacent to the edge of the stopper layer is processed with a laser due to process deviation in the laser process. For example, in a process of forming the dummy through hole, a problem may occur in which a portion of the upper surface of the first insulating layer 211 adjacent to an edge of the stopper layer is processed. Accordingly, in the embodiment, the stopper layer is formed to have a width greater than the lower width of the cavity 250 including the dummy through hole. Accordingly, a portion of the upper surface of the stopper layer may be exposed through the cavity 250, and the remaining portion of the upper surface of the stopper layer may not be exposed through the cavity 250. At this time, the stopper layer whose upper surface is exposed through the cavity 250 is removed when the dummy electrode is etched. In addition, the stopper layer whose upper surface is not exposed through the cavity 250 may form a second pad 221S of the first circuit pattern layer 221 without being removed during the etching process.

In this case, the second pad 221S may have a thickness different from that of the first pad 221P. For example, the second pad 221S may have a layer structure different from that of the first pad 221P.

Specifically, the first circuit pattern layer 221 includes a first metal layer 221-1 and a second metal layer 221-2. The first metal layer 221-1 of the first circuit pattern layer 221 is disposed on an upper surface of the first insulating layer 211. The first metal layer 221-1 of the first circuit pattern layer 221 may be a seed layer for electroplating the second metal layer 221-2 of the first circuit pattern layer 221. In this case, the first metal layer 221-1 of the first circuit pattern layer 221 may extend from an upper surface of the first insulating layer 211 to form a part of the first through electrode 231. For example, the first metal layer 221-1 of the first circuit pattern layer 221 may be disposed on an inner wall of a through hole penetrating the first insulating layer 211, thereby forming a first metal layer of the first through electrode 231.

In addition, the second metal layer 221-2 of the first circuit pattern layer 221 is an electrolytic plating layer formed by electroplating the first metal layer 221-1 of the first circuit pattern layer 221 as a seed layer. In this case, the second metal layer 221-2 of the first circuit pattern layer 221 may be disposed in a through hole penetrating the first insulating layer 211, thereby forming a second metal layer of the first through electrode 231.

Accordingly, the first pad 221P may include a first metal layer 221P-1 corresponding to the first metal layer 221-1 of the first circuit pattern layer 221 and a second metal layer 221-P2 corresponding to the second metal layer 221-2 of the first circuit pattern layer 221.

Meanwhile, in the process of forming the first circuit pattern layer 221, the first metal layer 221-1 is entirely formed on the upper surface of the first insulating layer 211, and the second metal layer 221-2 is partially formed on the upper surface of the first metal layer 221-1. In addition, when the second metal layer 221-2 is formed, a process of removing the first metal layer 221-1 that does not vertically overlap the second metal layer 221-2 by etching is performed to form the final first circuit pattern layer 221. In this case, in the process of removing the first metal layer 221-1, the embodiment does not remove the first metal layer 221-1 disposed in a region in which the cavity 250 is to be formed, preferably in a region in which the cavity 250 including the dummy through hole is to be formed. In addition, the first metal layer 221-1 which is not removed may constitute the stopper layer. Accordingly, in an embodiment, the stopper layer having the upper surface exposed through the cavity 250 is removed after the cavity 250 is finally formed. In addition, a portion of the first metal layer 221-1 used as the stopper layer that is not exposed through the cavity 250 may constitute the second pad 221S without being removed.

Accordingly, the first pad 221P may include a first metal layer 221P-1 and a second metal layer 221P-2, and the second pad 221S may include only the first metal layer 221-1.

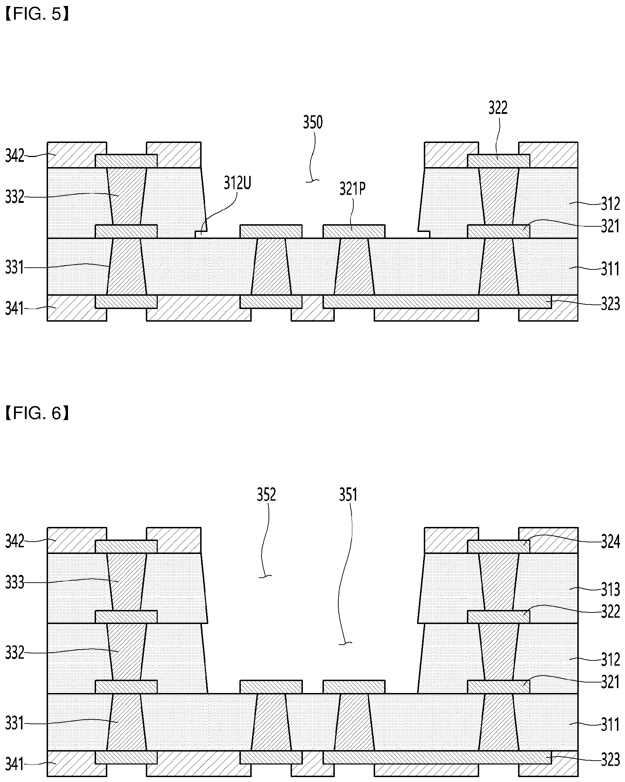

FIG. 5 is a view showing a circuit board according to a third embodiment.

Referring to FIG. 5, a circuit board includes a first insulating layer 311, a second insulating layer 312, a first circuit pattern layer 321, a second circuit pattern layer 322, a third circuit pattern layer 323, a first through electrode 331, a second through electrode 332, a first protective layer 341, and a second protective layer 342.

In this case, an overall structure of a circuit board of a third embodiment corresponds to the structure of the circuit board of FIGS. 1 and 4, and accordingly, a detailed description thereof will be omitted for a configuration having substantially the same structure.

In this case, the first circuit pattern layer 221 in the second embodiment includes a second pad 221S.

Alternatively, the circuit board of the third embodiment may include a recessed part 312U corresponding to a region in which the second pad 221S is formed.

That is, in the third embodiment, in a process of etching and removing the dummy electrode in a structure of the circuit board of the second embodiment, the second pad 221S may also be etched, thereby removing the second pad 221S. For example, the third embodiment may have a structure in which all stopper layers used in a process of forming the cavity including the dummy through hole are removed.

Accordingly, a recessed part 312U may be formed in the second insulating layer 312. The recessed part 312U may be formed at an inner wall of a cavity 350 adjacent to an upper surface of the first insulating layer 311 in the second insulating layer 312. For example, the recessed part 312U may be formed on a portion of an inner wall of the cavity 350 adjacent to an upper surface of the first insulating layer 311. At least a portion of the recessed part 312U may vertically overlap the first insulating layer 311 and the second insulating layer 312. Accordingly, in an embodiment, the upper surface of the first insulating layer 311 and the lower surface of the second insulating layer 312 may be spaced apart from each other in a region vertically overlapping the recessed part 312U. A depth of the recessed part 312U may correspond to a thickness of the first metal layer of the first circuit pattern layer described with reference to FIG. 4.

Accordingly, the embodiment allows the molding layer to fill the recessed part 312U in a process of filling the cavity with a molding layer, thereby improving the adhesion between the molding layer and the first insulating layer 311 and the second insulating layer 312.

FIG. 6 is a view showing a circuit board according to a fourth embodiment.

Referring to FIG. 6, the circuit board of the fourth embodiment includes a first insulating layer 311, a second insulating layer 312, a third insulating layer 313, a first circuit pattern layer 321, a second circuit pattern layer 322, a third circuit pattern layer 323, a fourth circuit pattern layer 324, a first through electrode 331, a third through electrode 333, a first protective layer 341, and a second protective layer 342.

In this case, an overall structure of a circuit board of a fourth embodiment corresponds to the structure of the circuit board of FIG. 1, and accordingly, a detailed description thereof will be omitted for a configuration having substantially the same structure.

Referring to FIG. 6, a circuit board may have a three-layer structure based on the number of layers of an insulating layer.

For example, the circuit board may include a first insulating layer 311, a second insulating layer 312, and a third insulating layer 313. That is, the circuit board of the fourth embodiment has a three-layer structure with the number of insulating layers, and thus differs from the previous embodiment in that a cavity is formed penetrating at least two insulating layers.

Accordingly, the circuit pattern layer of the circuit board further includes a fourth circuit pattern layer 324 disposed on the upper surface of the third insulating layer 313. In addition, the through electrode of the circuit board further includes a third through electrode 333 penetrating the third insulating layer 313.

In this case, the cavity may be formed in the second insulating layer 312 and the third insulating layer 313. For example, the cavity includes a first part 351 formed in the second insulating layer 313 and a second part 352 formed in the third insulating layer 313. In this case, the first part 351 of the cavity formed in the second insulating layer 312 is substantially the same as the cavity described in the previous embodiment, and thus a description thereof will be omitted.

The second part 352 of the cavity may be formed in the third insulating layer 313, and thus may be connected to the first part 351 of the cavity. For example, the second part 352 of the cavity may vertically overlap the first part 351 of the cavity.

The second part 352 of the cavity may have the same shape and structure as the shape and structure of the first part 351 of the cavity. For example, the second part 352 of the cavity may have the same shape as that of the first part 351 of the cavity, and may have an inclination angle corresponding to the inclination angle of the inner wall of the first part 351.

At this time, a width of the first part 351 of the cavity in a region adjacent to the upper surface of the second insulating layer 312 may be greater than a width of the first part 351 of the cavity in a region adjacent to the lower surface of the second insulating layer 312. Correspondingly, a width of the second part 352 of the cavity in a region adjacent to the upper surface of the third insulating layer 313 may be greater than a width of the second part 352 of the cavity in a region adjacent to the lower surface of the third insulating layer 313.

In addition, a width of the second part 352 of the cavity in a region adjacent to the lower surface of the third insulating layer 313 may be smaller than a width of the first part 351 of the cavity in a region adjacent to the upper surface of the second insulating layer 312.

Accordingly, an inner wall of the cavity including the first part 351 and the second part 352 may include an inflection part whose inclination angle changes at a portion connecting the first insulating layer 211 and the second part 352.

For example, an uppermost end of the inner wall of the first part 351 and a lowermost end of the inner wall of the second part 352 may not be directly connected to each other. For example, at least a portion of the lower surface of the third insulating layer 313 may be disposed between an uppermost end of the inner wall of the first part 351 and a lowermost end of the inner wall of the second part 352. Accordingly, an uppermost end of the inner wall of the first part 351 and a lowermost end of the inner wall of the second part 352 may be connected to each other through the lower surface of the third insulating layer 313. For example, the inner wall of the cavity may have a sawtooth shape in a vertical cross section.

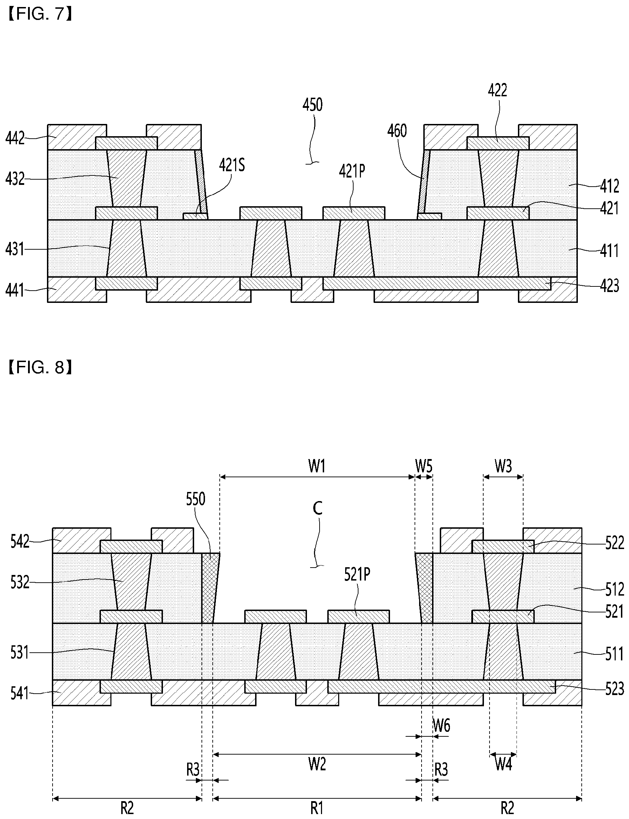

FIG. 7 is a view showing a circuit board according to a fifth embodiment.

Referring to FIG. 7, a circuit board includes a first insulating layer 411, a second insulating layer 412, a first circuit pattern layer 421, a second circuit pattern layer 422, a third circuit pattern layer 423, a first through electrode 431, a second through electrode 432, a first protective layer 441, and a second protective layer 442.

In this case, an overall structure of a circuit board of a fifth embodiment corresponds to the structure of the circuit board of FIGS. 1 and 4, and accordingly, a detailed description thereof will be omitted for a configuration having substantially the same structure.

A circuit board of a fifth embodiment further includes a metal layer 460 formed on the inner wall of the cavity 450 formed in the second insulating layer 412.

The metal layer 460 may be formed on an inner wall of the cavity 450. The metal layer 460 may be entirely formed on the inner wall of the cavity 450, but is not limited thereto. For example, the metal layer 460 may be formed on a part of the inner wall of the cavity 450. For example, the metal layer 460 may not be disposed on at least a part of an inner wall of the cavity 450.

The metal layer 460 may be a part of a dummy electrode formed on an inner wall of a cavity 450 in a process of forming the cavity 450.

For example, in an embodiment, the dummy electrode is formed at the boundary region to form the cavity 450 and then the dummy electrode is finally removed by etching to form the cavity 450. In this case, at least a part of the dummy electrode may not be removed during the process of etching the dummy electrode, and accordingly, a metal layer 460, which is a part of the dummy electrode, may be formed on the inner wall of the cavity 450. In addition, the metal layer 460 may not be connected to the first pad 421P but may be connected to the second pad 421S. Accordingly, according to an embodiment, when heat is generated from a device disposed in the cavity 450, and the generated heat may be transferred in an upward direction of the cavity 450 through the second pad 421S and the metal layer 460. Accordingly, the embodiment may improve heat dissipation characteristics of the semiconductor package by using the metal layer 460.

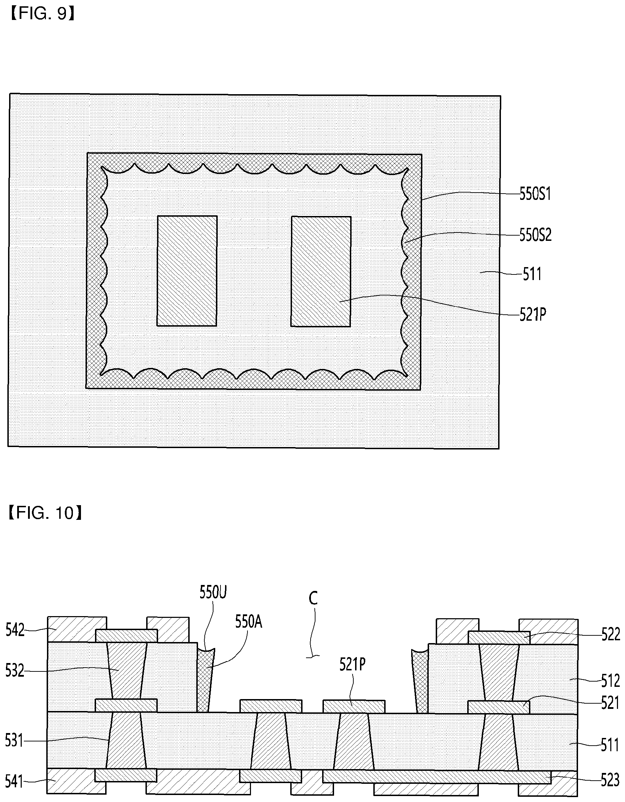

FIG. 8 is a view illustrating a circuit board according to a sixth embodiment, and FIG. 9 is a plan view omitting some components of the circuit board according to the sixth embodiment of FIG. 8.

Referring to FIGS. 8 and 9, the circuit board includes a first insulating layer 511, a second insulating layer 512, a first circuit pattern layer 521, a second circuit pattern layer 523, a first through electrode 531, a second through electrode 532, a first protective layer 541, and a second protective layer 542.

A circuit board according to a sixth embodiment of FIG. 8 may have a different inclination of the inner wall of the cavity C compared to the circuit board of the previous embodiment.

In addition, the circuit board according to the sixth embodiment may further include a shielding layer 550 disposed on the inner wall of the cavity C. The shielding layer 550 may shield between a region in which the cavity C of the circuit board is formed and a region other than the region. The shielding layer 550 may also be referred to as a shield layer.

In this case, an upper surface of the first insulating layer 511 may include a first region R1, a second region R2, and a third region R3. The third region R3 may mean a region vertically overlapping the shielding layer 550. Preferably, the third region R3 of an upper surface of the first insulating layer 511 may mean a region vertically overlapping a lower surface of the shielding layer 550.

The shielding layer 550 may be disposed on an inner wall of the cavity C. The shielding layer 550 may extend from the inner wall of the cavity C in a depth direction of the cavity C. For example, the shielding layer 550 may be disposed between an upper end of the inner wall of the cavity C adjacent to an upper surface of the second insulating layer 512 and a lower end of the inner wall of the cavity C adjacent to a lower surface of the second insulating layer 512.

The shielding layer 550 may be formed by filling an inside of a through hole passing through the second insulating layer 512 provided in a region in which the cavity C is to be formed with a metal material.

In this case, the third region R3 of the upper surface of the first insulating layer 511 is disposed to surround the first region R1. Accordingly, the shielding layer 550 may be disposed to surround a cavity region vertically overlapping the first region R1.

A width W5 of an upper surface and a width W4 of a lower surface of the shielding layer 550 may be different from each other. Preferably, the shielding layer 550 may include a region of which the width changes among an entire region in the thickness direction. Preferably, the width W5 of the upper surface of the shielding layer 550 may be greater than the width W4 of the lower surface of the shielding layer 550. For example, a second side surface 550S2 of the shielding layer 550 exposed through the cavity C may have an inclination in which the width of the shielding layer 550 increases toward the lower surface of the second insulating layer 512 from the upper surface of the second insulating layer 512. An inclination angle of the second side surface 550S2 of the shielding layer 550 may be less than 90 degrees. The second side surface 550S2 of the shielding layer 550 may refer to a side surface adjacent to the cavity C or a side surface exposed through the cavity C in the shielding layer 550 disposed at one side of the cavity C. That is, the shielding layer 550 may include a first side surface 550S1 contacting the inner wall of the second insulating layer 512 and a second side surface 550S2 opposite to the first side surface 550S1 and exposed through the cavity C.

The inclination angle of the second side surface 550S2 of the shielding layer 550 may mean an internal angle between a lower surface of the cavity C (e.g., an upper surface of the first insulating layer 511 that does not contact the cavity C and the shielding layer 550) and the second side surface 550S2 of the shielding layer 550.

The inclination angle of the second side surface 550S2 of the shielding layer 550 may satisfy a range between 75 and 89 degrees. For example, the inclination angle of the second side surface 550S2 of the shielding layer 550 may satisfy a range between 78 and 87 degrees. For example, the inclination angle of the second side surface 550S2 of the shielding layer 550 may satisfy a range between 80 and 85 degrees.

If the inclination angle of the second side surface 550S2 of the shielding layer 550 is less than 75 degrees, a difference between an upper width and a lower width of the cavity C formed therethrough is increased, and thus processability may be deteriorated in the process of mounting the device in the cavity C. For example, if the inclination angle of the second side surface 550S2 of the shielding layer 550 is less than 75 degrees, a problem in which the upper end of the shielding layer 550 comes into contact with the device may occur in the process of mounting the device in the cavity C, thereby causing a problem in which the mounting position of the device is misaligned. In addition, if the inclination angle of the second side surface 550S2 of the shielding layer 550 is less than 75 degrees, an overall size of the cavity C including the shielding layer 550 may be increased in order to mount a device having a desired size in the cavity C, and thus circuit integration may be deteriorated. For example, if the inclination angle of the second side surface 550S2 of the shielding layer 550 is greater than 75 degrees, a dead region in which the circuit pattern layer is not disposed in the circuit board may increase, thereby increasing a width of the circuit board in a horizontal direction and a thickness of the circuit board in a vertical direction may increase.

In addition, if the inclination angle of the second side surface 550S2 of the shielding layer 550 is greater than 89 degrees, a function of the shielding layer 550 may be deteriorated. For example, the shielding layer 550 may function as a heat dissipating heat generated from a device mounted in the cavity C to the outside while preventing signal interference. In this case, if the inclination angle of the second side surface 550S2 of the shielding layer 550 is greater than 90 degrees, it means that the width of the lower surface of the shielding layer 550 is greater than the width of the upper surface. If the width of the lower surface of the shielding layer 550 is greater than the width of the upper surface, the heat transfer path in the shielding layer 550 is formed in a relatively wide direction with respect to the upper and lower surfaces of the shielding layer 550, and through this, heat may not be efficiently transferred to an outside of the circuit board (for example, in a direction toward an upper surface of the shielding layer 550). For example, if the inclination angle of the second side surface 550S2 of the shielding layer 550 is greater than 90 degrees, the heat dissipation effect achieved by the shielding layer 550 may be insufficient.

Meanwhile, the second side surface 550S2 of the shielding layer 550 may constitute an inner wall of the cavity C. For example, an inner wall of the cavity C in the second insulating layer 512 is in contact with the shielding layer 550. Accordingly, a substantial inner wall of the cavity C may be a second side surface 550S2 of the shielding layer 550 rather than an inner wall of the cavity C in the second insulating layer 512.

Meanwhile, the shielding layer 550 as described above is not electrically connected to the first circuit pattern layer 521, the second circuit pattern layer 522, the third circuit pattern layer 523, the first through electrode 531, and the second through electrode 532. In this case, at least one of the first circuit pattern layer 521 and the second circuit pattern layer 522 includes a mask pattern (or a stopper) used as a mask in a process of forming a through hole penetrating the second insulating layer 512 corresponding to the shielding layer 550. The mask pattern may not be electrically connected to the first circuit pattern layer 521, the second circuit pattern layer 522, the third circuit pattern layer 523, the first through electrode 531, and the second through electrode 532, and may be connected to the shielding layer 550.

As described above, a width of the upper surface W5 of the shielding layer 550 is greater than a width of the lower surface W6. Accordingly, the cavity C may have an upper width W1 and a lower width W2 different from each other. For example, the upper width W1 of the cavity C may be less than the lower width W2 of the cavity C. Accordingly, a vertical cross-sectional shape of the cavity C may have a trapezoidal shape in which an upper width is less than a lower width.

Meanwhile, a width of the shielding layer 550 may be smaller than a width of the second through electrode 532 horizontally overlapping the shielding layer 550.

A through hole corresponding to the shielding layer 550 is formed using a part of a wavelength of a Gaussian beam in a state in which the mask pattern is formed. The through hole corresponding to the second through electrode 532 is formed using all of the wavelength of the Gaussian beam.

For example, the wavelength of the Gaussian beam may have a V-shaped parabola shape with respect to an energy center point. The through hole corresponding to the second through electrode 532 is formed using all of the wavelengths of the V-shaped parabola-shaped Gaussian beam. Unlike this, the through hole corresponding to the shielding layer 550 is formed using some of the wavelengths of the V-shaped parabola-shaped Gaussian beam. For example, a part of the wavelengths of the V-shaped parabola-shaped Gaussian beam are provided to the mask pattern, and only the remaining part is provided to the second insulating layer 512 to form the through hole corresponding to the shielding layer 550. Accordingly, the embodiment may reduce a width of the shielding layer 550, thereby minimizing a problem of increasing a dead region caused by the shielding layer 550.

Meanwhile, an inclination angle of the first side surface 550S1 may be greater than an inclination angle of the second side surface 550S2. An inclination angle of the first side surface 550S1 of the shielding layer 550 may be close to 90 degrees. For example, an inclination angle of the first side surface 550S1 of the shielding layer 550 may refer to an internal angle between a lower surface of the cavity C (e.g., an upper surface of the first insulating layer 511 exposed through the cavity C) and the first side surface 550S1.

The inclination angle of the first side surface 550S1 of the shielding layer 550 may satisfy a range between 91 and 115 degrees. The inclination angle of the first side surface 550S1 of the shielding layer 550 may satisfy a range between 93 and 112 degrees. The inclination angle of the first side surface 550S1 of the shielding layer 550 may satisfy a range between 95 and 110 degrees.

When the inclination angle of the first side surface 550S1 of the shielding layer 550 is less than 91 degrees, processability in the process of forming a through hole corresponding to the shielding layer 550 is deteriorated, and thus a time required to form the shielding layer 550 may be increased.

In addition, if the inclination angle of the first side surface 550S1 of the shielding layer 550 is greater than 115 degrees, a difference between the width of the upper surface and the width of the lower surface of the shielding layer 550 increases, thereby increasing a dead region in which the circuit pattern layer cannot be disposed.

Meanwhile, as described above, the width of the shielding layer 550 may be smaller than the width of the second through electrode 532.

Specifically, a width W5 of an upper surface of the shielding layer 550 may be less than a width W3 of an upper surface of the second through electrode 532. In addition, a width W6 of a lower surface of the shielding layer 550 may be smaller than a width W4 of a lower surface of the second through electrode 532.

For example, the width W5 of the upper surface of the shielding layer 550 may satisfy a range of 20% to 75% of the width W3 of the upper surface of the second through electrode 532. For example, the width W5 of the upper surface of the shielding layer 550 may satisfy a range of 25% to 70% of the width W3 of the upper surface of the second through electrode 532. For example, the width W5 of the upper surface of the shielding layer 550 may satisfy a range of 30% to 65% of the width W3 of the upper surface of the second through electrode 532.

If the width W5 of the upper surface of the shielding layer 550 is less than 20% of the width W3 of the upper surface of the second through electrode 532, processability in the process of forming the through hole corresponding to the shielding layer 550 is deteriorated, and thus the time required to form the shielding layer 550 may increase. In addition, if the width W5 of the upper surface of the shielding layer 550 exceeds 75% of the width W3 of the upper surface of the second through electrode 532, an area occupied by the shielding layer 550 in the cavity C may increase, and accordingly, the circuit integration may decrease or the volume of the circuit board may increase as the dead region increases.

Furthermore, correspondingly, a width W6 of the lower surface of the shielding layer 550 may satisfy a range of 20% to 75% of a width W4 of the lower surface of the second through electrode 532. For example, the width W6 of the lower surface of the shielding layer 550 may satisfy a range of 25% to 70% of the width W4 of the lower surface of the second through electrode 532. For example, the width W6 of the lower surface of the shielding layer 550 may satisfy a range of 30% to 65% of the width W4 of the lower surface of the second through electrode 532.

Meanwhile, as described above, the shielding layer 550 may be formed by filling a metal material inside a through hole formed in a region of the second insulating layer 512 that vertically overlaps the third region R2. In this case, the through hole corresponding to the shielding layer 550 may have a structure surrounding an upper region of the first region R1 of the upper surface of the first insulating layer 511. Thus, the through hole corresponding to the shielding layer 550 has a structure including a plurality of hole parts (not shown) connected to each other so as to surround the upper region of the first region R1.

Accordingly, the second side surface 550S2 (a side surface exposed through the cavity C) of the shielding layer 550 may have a planar shape including a plurality of convex parts convex toward the cavity C.

For example, the second side surface 550S2 of the shielding layer 550 may include a plurality of convex parts which have a curvature in a width direction or a length direction (e.g., a horizontal direction) perpendicular to the thickness direction and are convex toward the cavity C. The plurality of convex parts may be connected to each other.

Meanwhile, in FIG. 9, a planar shape of the first side surface 550S1 of the shielding layer 550 is illustrated as a plane instead of a curved surface, but the embodiment is not limited thereto. For example, the first side surface 550S1 of the shielding layer 550 may include a convex part that is convex in a direction away from the cavity C or in a direction toward the inside of the second insulating layer 512. However, in an embodiment, the through hole corresponding to the shielding layer 550 is formed using a part of the wavelength of the Gaussian beam, and thus the convex part of the first side surface 550S1 may have a size different from that of the convex part of the second side surface 550S2. For example, a horizontal length of the convex part of the first side surface 550S1 may be smaller than a horizontal length of the convex part of the second side surface 550S2. In other words, the convex part of the first side surface 550S1 and the convex part of the second side surface 550S2 correspond to a planar shape of the wavelength of the Gaussian beam. In this case, in an embodiment, the through hole of the shielding layer 550 is formed using a part of the Gaussian beam. Accordingly, a radius of curvature of the convex part of the first side surface 550S1 may be greater than a radius of curvature of the convex part of the second side surface 550S2. For example, the convex part of the first side surface 550S1 may be substantially closer to a straight line than the convex part of the second side surface 550S2.

FIG. 10 is a view showing a circuit board according to a seventh embodiment.

Referring to FIG. 10, the circuit board includes a first insulating layer 511, a second insulating layer 512, a first circuit pattern layer 522, a third circuit pattern layer 523, a first through electrode 531, a second through electrode 532, a shielding layer 550A, a first protective layer 541, and a second protective layer 542.

In this case, an overall structure of a circuit board of a second embodiment is substantially the same as that of the circuit board of FIG. 1, and accordingly, a detailed description thereof will be omitted for substantially the same structure.

A shielding layer 550A includes at least one concave part 550U. For example, a concave part 550U concave toward the lower surface of the shielding layer 550A may be formed on the upper surface of the shielding layer 550A.

The concave part 550U may be formed by removing a part of the upper surface of the shielding layer 550A together in an etching process of the mask pattern. As the concave part 550U is formed in the shielding layer 550A, at least a part of the inner wall of the second insulating layer 512 may not be in contact with the shielding layer 550A. For example, at least a portion of the inner wall of the second insulating layer 512 may horizontally overlap the concave part 550U.

In this case, a semiconductor package may be manufactured by forming a molding layer for molding the cavity C in a state in which the device is mounted in the cavity C. In this case, the molding layer has a higher adhesion to the dielectric layer than that to the metal layer.

Accordingly, in an embodiment, at least a portion of the molding layer is in contact with at least a portion of the inner wall of the second insulating layer 512 while filling the concave part 550U of the shielding layer 550A. Accordingly, an embodiment may improve the adhesion between the second insulating layer 512 and the molding layer.

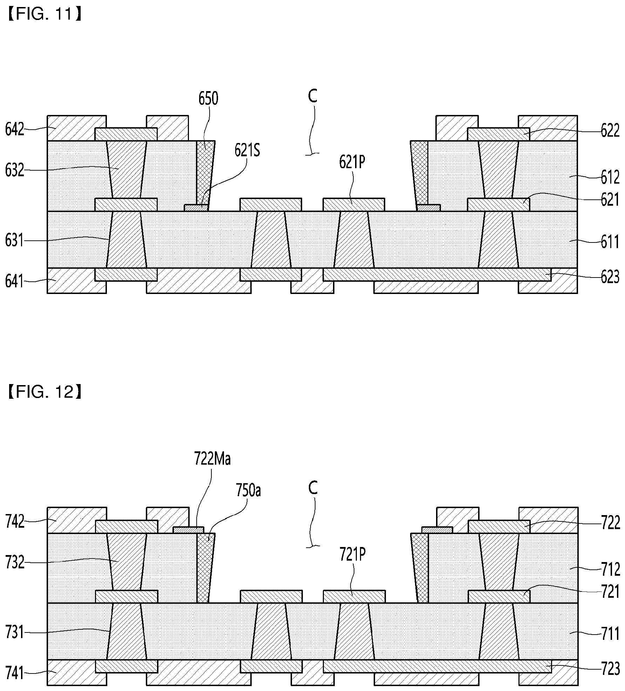

FIG. 11 is a view illustrating a circuit board according to an eighth embodiment.

Referring to FIG. 11, a circuit board includes a first insulating layer 611, a second insulating layer 612, a first circuit pattern layer 621, a second circuit pattern layer 622, a third circuit pattern layer 623, a first through electrode 631, a second through electrode 632, a shielding layer 650, a first protective layer 641, and a second protective layer 642.

In this case, an overall structure of a circuit board of an eighth embodiment corresponds to a structure of the circuit board of FIG. 8, and accordingly, a detailed description thereof will be omitted for a configuration having substantially the same structure.

A first circuit pattern layer 621 includes a first pad 621P disposed in a first region R1 of an upper surface of the first insulating layer 611.

In addition, the first circuit pattern layer 621 includes a second pad 621S disposed at a boundary region of the cavity C among the upper surfaces of the first insulating layer 611. The second pad 621S may be disposed at a region between the first region R1 and the second region R2 on the upper surface of the first insulating layer 611.

Preferably, the second pad 621S may be disposed in a third region R3 of the upper surface of the first insulating layer 611 vertically overlapping the shielding layer 650. In addition, the second pad 621S may be partially disposed not only in a third region R3 but also in a second region R2. For example, a width of the second pad 621S may be greater than a width of the lower surface of the shielding layer 650. Accordingly, an upper surface of the second pad 621S may include a portion which is in contact with the shielding layer 650, and a portion which is in contact with the second insulating layer 612.

That is, an upper surface of the second pad 621S may be in contact with the second insulating layer 612 and the shielding layer 650. A side surface of the second pad 621S may not be in contact with the second insulating layer 612 and the shielding layer 650. For example, a side surface of the second pad 621S may be exposed through the cavity C. The second pad 621S may correspond to the second pad 221S illustrated in FIGS. 4 and 5. Thus, a detailed description thereof will be omitted.

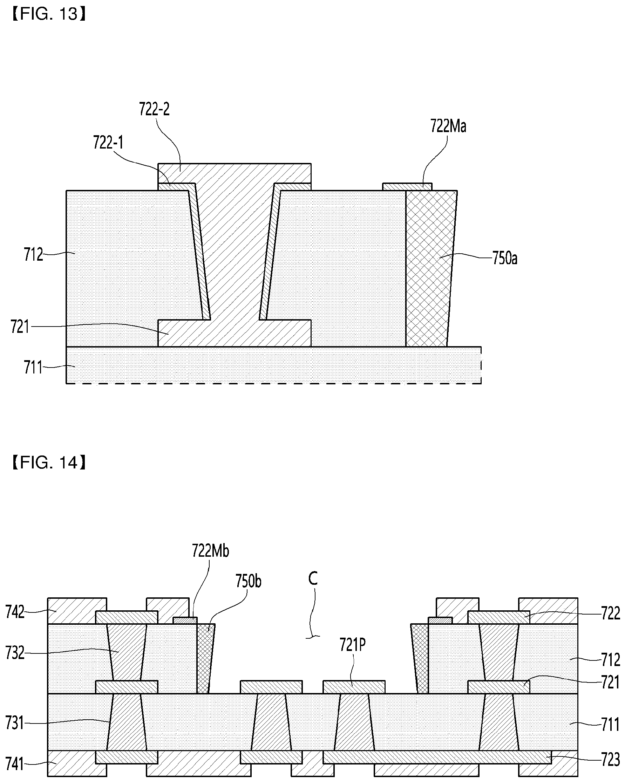

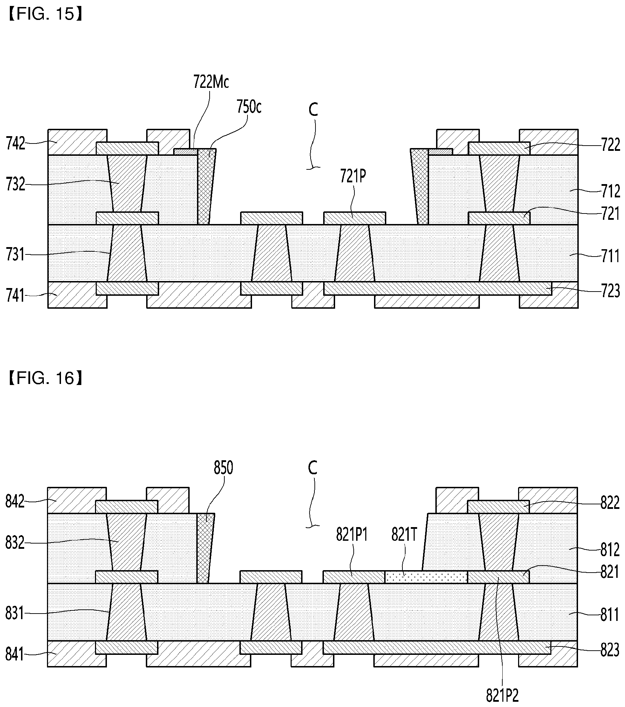

FIG. 12 is a view showing a circuit board according to a ninth embodiment, FIG. 13 is a view showing a detailed layer structure of a portion of the circuit board of FIG. 12, FIG. 14 is a view showing a first modified example of the third pad of FIG. 12, and FIG. 15 is a view showing a second modified example of the third pad of FIG. 12.

Referring to FIGS. 12 and 13, a circuit board includes a first insulating layer 711, a second insulating layer 712, a first circuit pattern layer 721, a second circuit pattern layer 722, a third circuit pattern layer 723, a first through electrode 731, a second through electrode 732, a shielding layer 750, a first protective layer 741, and a second protective layer 742. A description of the circuit board of the ninth embodiment that is substantially the same as that of the previous embodiment will be omitted.

The second circuit pattern layer 722 may have a plurality of layer structures. The second circuit pattern layer 722 may include a third pad 722Ma disposed on the upper surface of the third insulating layer 712 vertically overlapping the third region R3.

In this case, the third pad 722Ma may be disposed in a region vertically overlapping the third region R3 of the upper surface of the second insulating layer 712, for example, in a region vertically overlapping the shielding layer 750. However, the embodiment is not limited thereto, and as illustrated in FIGS. 12 and 13, at least a portion of the third pad 722Ma may be disposed in a region vertically overlapping the second region R2 while being adjacent to the cavity C of the upper surface of the second insulating layer 712.

In one embodiment, the third pad 722Ma may include a first portion disposed on the upper surface of the second insulating layer 712 and a second portion extending from the first portion toward the cavity C and disposed on the upper surface of the shielding layer 750.

In this case, at least a portion of the upper surface of the shielding layer 750 may be in contact with the third pad 722 Ma, and the remaining portion of the upper surface of the shielding layer 750 may not be in contact with the shielding layer 750. For example, at least a portion of the upper surface of the shielding layer 750 may be exposed.

The third pad 722Ma may be a part of a mask layer used when forming the through hole and cavity C corresponding to the shielding layer 750 according to the embodiment. For example, the third pad 722Ma may be a mask pattern formed to correspond to a position where the through hole of the shielding layer 750 is to be formed.

And, as in the first embodiment, the third pad 722 Ma may be removed by etching after the cavity C is formed, unlike this, the third pad 722 Ma may not be removed and remain on the upper surface of the second insulating layer 712.

In this case, the second circuit pattern layer 121 includes the third pad 722Ma and a fourth pad (not shown) horizontally spaced apart from the third pad 722Ma. For example, the fourth pad is a signal pad, and may mean a pad or trace connected to the second through electrode 332.

In this case, the third pad 722Ma may have a thickness different from that of the fourth pad. For example, the third pad 722Ma may have a layer structure different from that of the fourth pad.

Specifically, the second circuit pattern layer 722 includes a first metal layer 722-1 and a second metal layer 722-2. The first metal layer 722-1 of the second circuit pattern layer 722 is disposed on an upper surface of the second insulating layer 712. The first metal layer 722-1 of the second circuit pattern layer 722 may be a seed layer for electroplating the second metal layer 722-2 of the second circuit pattern layer 722. In this case, the first metal layer 722-1 of the second circuit pattern layer 722 may extend from an upper surface of the second insulating layer 712 to form a part of the second through electrode 332. For example, the first metal layer 722-1 of the second circuit pattern layer 722 is disposed on an inner wall of the through hole penetrating the second insulating layer 712 and, thereby forming a first metal layer of the second through electrode 332.

In addition, the second metal layer 722-2 of the second circuit pattern layer 722 is an electrolytic plating layer formed by electroplating the first metal layer 722-1 of the second circuit pattern layer 722 as a seed layer. In this case, the second metal layer 722-2 of the second circuit pattern layer 722 is also disposed in a through hole penetrating the second insulating layer 712, thereby forming a second metal layer of the second through electrode 332.

Accordingly, a fourth pad of the second circuit pattern layer 121 may include a first metal layer 722-1 and a second metal layer 722-2.

Meanwhile, in a process of forming the second circuit pattern layer 722, the second metal layer 722-2 is partially formed on the upper surface of the first metal layer 722-1 in a state in which the first metal layer 722-1 is entirely formed on the upper surface of the second insulating layer 712. In addition, when the second metal layer 722-2 is formed, a process of removing the first metal layer 722-1 that does not vertically overlap the second metal layer 722-2 by etching is performed to form a final second circuit pattern layer 722. In this case, in the embodiment, in the process of removing the first metal layer 722-1, a portion of the first metal layer 722-1 disposed adjacent to a region in which the through hole of the shielding layer 750a is to be formed is not removed. The first metal layer 722-1 which is not removed may be used as a mask in a process of forming the through hole of the shielding layer 750a.

Accordingly, the third pad 722Ma has a structure including only the first metal layer 722-1 of the second circuit pattern layer 722 and may be partially disposed on the upper surface of the second insulating layer 712 adjacent to the cavity C.

In this case, depending to a process condition in a process of forming the through hole of the shielding layer 750a, the through hole may be selectively formed only in a region that does not vertically overlap the third pad 722Ma used as the mask pattern, and unlike this, at least a portion of the through hole may be formed to vertically overlap the third pad 722Ma as shown in FIG. 12. Accordingly, at least a portion of the upper surface of the third pad 722Ma may be covered with the third pad 722Ma as shown in FIG. 12.

Also, as shown in FIG. 14, in a process of forming the through hole of the shielding layer 750b, the through hole may be selectively formed in the second insulating layer 712 that does not vertically overlap the third pad 722Mb.

Accordingly, the third pad 722Mb may be selectively formed only on the upper surface of the second insulating layer 712 adjacent to the upper surface of the shielding layer 750b without contacting the upper surface of the shielding layer 750b.

In this case, the upper surface of the shielding layer 750b may not be higher than the upper surface of the second insulating layer 712. For example, the upper surface of the shielding layer 750b may be formed on the same plane as the upper surface of the second insulating layer 712 or may be positioned lower than the upper surface of the second insulating layer 712.

Also, as shown in FIG. 15, in the process of forming the through hole of the shielding layer 750c, the through hole may be selectively formed in the second insulating layer 712 that does not vertically overlap the third pad 722Mc.

Accordingly, the third pad 722Mc may be selectively formed only on the upper surface of the second insulating layer 712 adjacent to the upper surface of the shielding layer 750c without contacting the upper surface of the shielding layer 750c.

In this case, the upper surface of the shielding layer 750c may be positioned higher than the upper surface of the second insulating layer 712. For example, in a process of filling the through hole, the upper surface of the shielding layer 750c may be positioned higher than the upper surface of the second insulating layer 712. For example, the upper surface of the shielding layer 750c may have a height corresponding to the upper surface of the third pad 722Mc. Accordingly, at least a portion of the side surface of the shielding layer 750c may be in direct contact with the side surface of the third pad 722Mc.

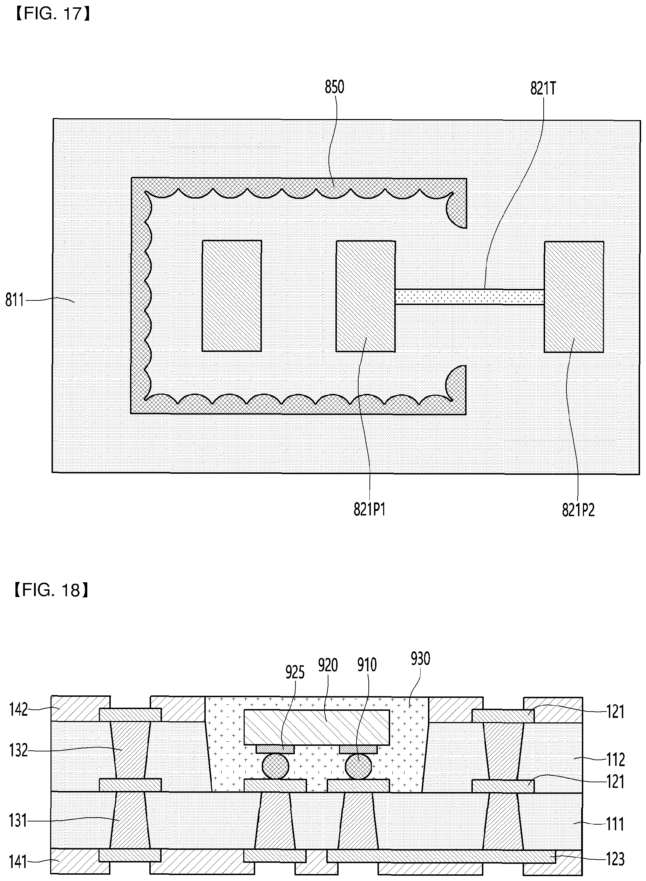

FIG. 16 is a view showing a circuit board according to a tenth embodiment, and FIG. 17 is a plan view omitting some components of the circuit board of FIG. 16.

Referring to FIGS. 16 and 17, the circuit board includes a first insulating layer 811, a second insulating layer 812, a first circuit pattern layer 821, a second circuit pattern layer 822, a third circuit pattern layer 823, a first through electrode 831, a second through electrode 832, a shielding layer 850, a first protective layer 841, and a second protective layer 842.

The circuit board of the tenth embodiment may have a different structure of the shielding layer 850 and the first circuit pattern layer 821 compared to the structure of the circuit board of the previous embodiment.

The shielding layer 850 may not be formed on at least some of the inner walls of the second insulating layer 812 including the cavity C.

For example, as shown in FIG. 16, when a planar shape of the cavity C has a rectangular shape, the shielding layer 850 may not be disposed on at least one of four inner wall surfaces of the second insulating layer 812 including the cavity C.

Accordingly, the embodiment may allow a part of the first circuit pattern layer 821 to be disposed in a region vertically overlapping the inner wall of the second insulating layer 812 in which the shielding layer 850 is not disposed.

For example, the first circuit pattern layer 821 in an embodiment includes a first-first pad 821 P1 disposed in a region vertically overlapping the first region R1 among the upper surface of the first insulating layer 811, and a first-second pad 821P2 disposed in a region vertically overlapping the second region R2. In this case, the shielding layer 850 is not disposed on at least a portion of the inner wall of the second insulating layer 812. Accordingly, a trace 821T directly connecting the first-first pad 821P1 and the first-second pad 821P2 may be disposed on the upper surface of the first insulating layer 811 that vertically overlaps the inner wall of the second insulating layer 812 on which the shielding layer 850 is not disposed.

Accordingly, the trace 821T includes a first portion directly connected to the first-first pad 821P1 and including an upper surface exposed through the cavity C and a second portion directly connected to the first-second pad 821P2 and including an upper surface covered with the second insulating layer 812. In addition, at least a portion between the first portion and the second portion of the trace 821T may vertically overlap an inner wall of the second insulating layer 812 including the cavity C.

FIG. 18 is a view showing a semiconductor package according to an embodiment.

Referring to FIG. 18, a semiconductor package according to an embodiment includes a device 920 mounted in the cavity 150 illustrated in FIG. 1.

However, the semiconductor package of an embodiment may include a circuit board illustrated in any one of FIGS. 3 to 17 other than FIG. 1.

That is, the circuit boards described above may be used as a package substrate for mounting a device 920 such as a chip.

As described above, the circuit board includes a cavity 150, and the first pad 121P of the first circuit pattern layer 121 may be disposed in the cavity 150.

A connection part 910 may be disposed on the first pad 121P.

In this case, a planar shape of the connection part 910 may be circular. The connection part 910 may be disposed on the first pad 121P to electrically connect the device 920 and the first pad 121P while fixing the device 920. To this end, the connection part 910 may include a conductive material. For example, the connection part 910 may be a solder ball, but is not limited thereto.

An electronic device 920 may be mounted on the connection part 910.

In this case, the electronic device 920 may be an electronic component disposed in the cavity 150 of the circuit board, which may be divided into an active device and a passive device.

In this case, the device 920 may include a terminal 925. The terminal 925 of the device 920 may be electrically connected to the first pad 121P through the connection part 910. Also, a molding layer 930 may be disposed in the cavity 150. The molding layer 930 may be disposed while molding the device 920 in the cavity 150. The molding layer 930 may prevent a foreign material from penetrating into the cavity 150 while protecting the device 920.

Hereinafter, a method of manufacturing a circuit board according to an embodiment will be described with reference to the accompanying drawings.

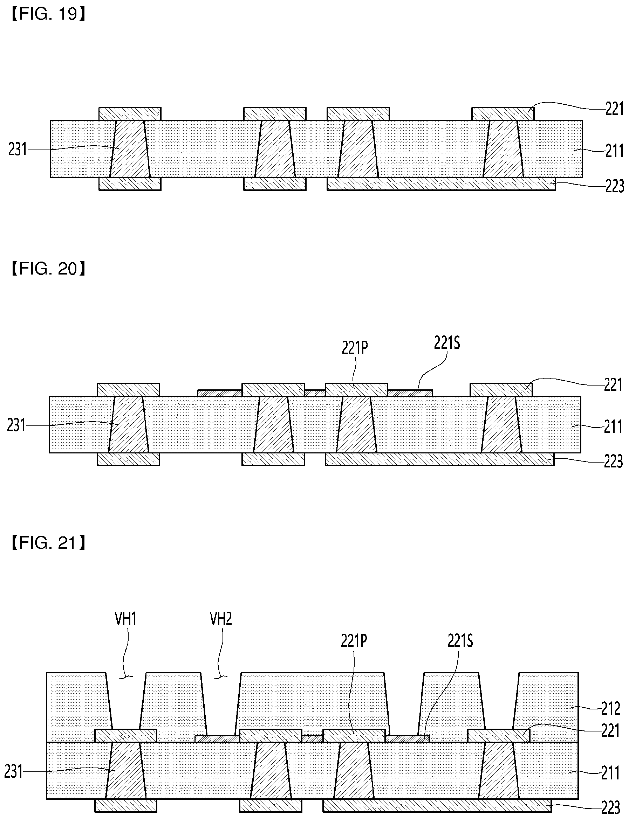

FIGS. 19 to 26 are views showing a method of manufacturing the circuit board shown in FIG. 3 in order of processes.

Before explaining the method of manufacturing the circuit board of the present application, a circuit board may have three or more layers based on an insulating layer. In addition, the circuit board may include a core layer. However, hereinafter, for convenience of explanation, it will be described that the circuit board is a coreless substrate and includes two insulating layers. In addition, the circuit board includes a cavity, and the cavity may be formed by opening at least one insulating layer.

In this case, the cavity may be formed by opening two or more insulating layers, but hereinafter, a process of forming by opening only one layer of insulating layers will be described.

In addition, the circuit board of the embodiment may have an Embedded Trace Substrate (ETS) structure.

Referring to FIG. 19, an embodiment prepares a first insulating layer 211.

In an embodiment, a process of forming each of the first through electrode 231, the first circuit pattern layer 221, and the third circuit pattern layer 223 on the first insulating layer 211 may be performed. For example, in an embodiment, a through hole (not shown) penetrating the first insulating layer 211 is formed. In addition, in an embodiment, a process of forming a first metal layer, which is a seed layer, on an upper surface, a lower surface of the first insulating layer 211 and an inner wall of the through hole may be performed. Next, in an embodiment, electroplating may be performed on the first metal layer to form the second metal layer. In addition, the first metal layer and the second metal layer may constitute a first circuit pattern layer 221, a third circuit pattern layer 223, and a first through electrode 231, respectively.

Next, the embodiment may proceed with a process of removing a part of the first metal layer used as the seed layer for electroplating the second metal layer. In this case, the first metal layer includes a region vertically overlapping the second metal layer and a region that does not vertically overlap the second metal layer. And, in a general process of etching the first metal layer, the region that does not vertically overlap the second metal layer is entirely removed. Alternatively, as illustrated in FIG. 20, an embodiment does not remove a portion of the first metal layer corresponding to a region in which the cavity 250 is to be formed. In addition, the first metal layer that is not removed may be used as a stopper layer in a laser process performed to form a cavity.

Next, referring to FIG. 21, an embodiment forms a second insulating layer 212 on the first insulating layer 211.

In addition, an embodiment forms a through hole in the second insulating layer 212.

In this case, the through-hole may be divided into a plurality of through-holes according to functions. For example, the through-hole includes a first through-hole VH1 formed to correspond to a region in which the second through-electrode 232 is to be formed. Also, the through-hole includes a second through-hole VH2 formed at a boundary region in which the cavity 250 is to be formed. In this case, the second through-hole VH2 may mean a dummy through-hole described in the structure of the circuit board. In this case, the first through-hole VH1 vertically overlaps at least a portion of the first circuit pattern layer 221, and accordingly, an upper surface of a pad to be connected to the second through electrode 232 in the first circuit pattern layer 221 may be exposed. In addition, the second through-hole VH2 may be formed by exposing an upper surface of a stopper layer 221S which has not been removed to be used as a stopper layer among the first metal layers.

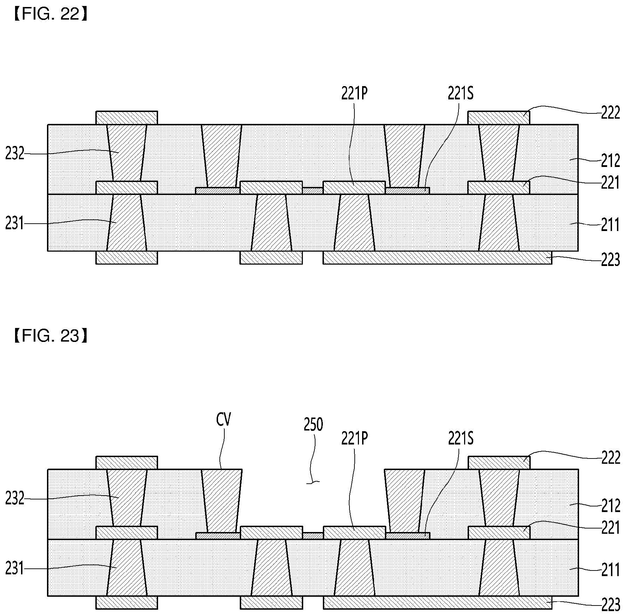

Next, referring to FIG. 22, an embodiment forms a second through electrode 232 and a dummy electrode CV filling the first through hole VH1 and the second through hole VH2. Also, an embodiment performs a process of forming a second circuit pattern layer 222 on the upper surface of the second insulating layer 212. In this case, the second circuit pattern layer 222 may not be disposed on the dummy electrode CV. However, an embodiment is not limited thereto, and a portion of the second circuit pattern layer 222 may also be disposed on the dummy electrode CV.

Next, referring to FIG. 23, in the embodiment, the dummy electrode CV may be used as a mask to process the second insulating layer 212 of the inner region of the dummy electrode CV to form a part of the cavity 250.

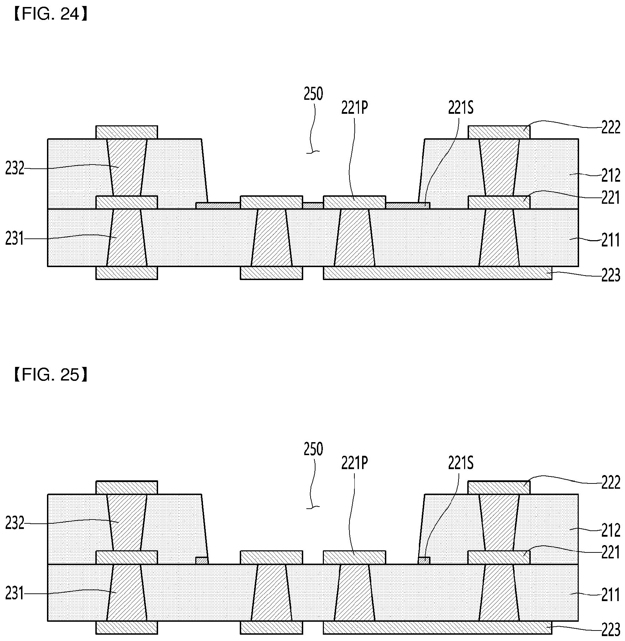

Next, referring to FIGS. 24 and 25, the embodiment may proceed with a process of removing the dummy electrode CV and the stopper layer 221S by an etching. In this case, a process of the etching of the dummy electrode CV and the stopper layer 221S is illustrated as separate processes, but the present invention is not limited thereto. For example, the embodiment may proceed with a process of removing the stopper layer 221S together with the dummy electrode CV while removing the dummy electrode CV by the etching. Also, when the dummy electrode CV is etched, a part of the dummy electrode CV may not be removed but may remain as a metal layer 460 on the inner wall of the cavity 250.

In addition, the stopper layer 221S includes a region including an upper surface exposed through the cavity 250, and a region that does not include an upper surface exposed through the cavity 250. In addition, the region of the stopper layer 221S through which the upper surface is exposed through the cavity 250 is removed in the etching process. Alternatively, the region of the stopper layer 221S through which the upper surface is not exposed through the cavity 250 may not be removed, but may remain as a second pad. Alternatively, the stopper layer 221S may be entirely removed, and thus a recessed part 312U recessed inward from the inner wall of the second insulating layer 212 may be formed.

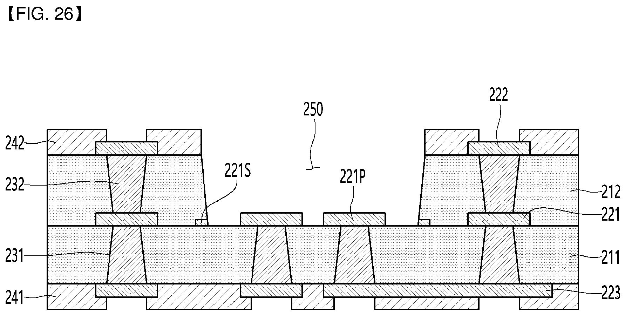

Next, referring to FIG. 26, the embodiment may proceed with a process of forming a first protective layer 241 on the lower surface of the first insulating layer 211 and forming a second protective layer 242 on the upper surface of the second insulating layer 212.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

Features, structures, effects, etc. described in the above embodiments are included in at least one embodiment, and it is not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and variations should be interpreted as being included in the scope of the embodiments.

In the above, the embodiment has been mainly described, but this is only an example and does not limit the embodiment, and those of ordinary skill in the art to which the embodiment pertains will appreciate that various modifications and applications not illustrated above are possible without departing from the essential characteristics of the present embodiment. For example, each component specifically shown in the embodiment can be implemented by modification. And the differences related to these modifications and applications should be interpreted as being included in the scope of the embodiments set forth in the appended claims.

## Claims

1. A circuit board comprising:
a first insulating layer; and
a second insulating layer disposed on an upper surface of the first insulating layer,
wherein the second insulating layer includes a cavity, and
wherein the cavity has a planar shape including a plurality of convex parts convex toward an inner direction of the second insulating layer.

2. The circuit board of claim 1, further comprising:
a first through electrode passing through the first insulating layer; and
a second through electrode passing through the second insulating layer,
wherein an inclination angle of an inner wall of the cavity corresponds to an inclination angle of a side surface of the second through electrode.

3. The circuit board of claim 2, wherein the inner wall of the cavity includes:
a first inner wall positioned at one side of the cavity, and
a second inner wall positioned at the other side of the cavity and facing the first inner wall,
wherein the second through electrode includes:
a first side surface positioned at one side of the second through electrode, and
a second side surface positioned at the other side of the second through electrode opposite to the first side surface,
wherein an inclination angle of the first inner wall of the cavity corresponds to an inclination angle of the first side surface of the second through electrode, and
wherein an inclination angle of the second inner wall of the cavity corresponds to an inclination angle of the second side surface of the second through electrode.

4. The circuit board of claim 3, wherein the inclination angle of the first inner wall is an internal angle between a lower surface of the cavity and the first inner wall,
wherein the inclination angle of the second inner wall is an internal angle between the lower surface of the cavity and the second inner wall,
wherein the inclination angle of the first side surface of the second through electrode is an internal angle between a lower surface of the second through electrode and the first side surface, and
wherein the inclination angle of the second side surface of the second through electrode is an internal angle between the lower surface of the second through electrode and the second side surface, and
wherein the inclination angle of each of the first inner wall, the second inner wall, the first side surface, and the second side surface satisfies a range of 91 to 115 degrees.

5. The circuit board of claim 1, further comprising:
a metal layer disposed on at least a part of the inner wall of the cavity.

6. The circuit board of claim 1, further comprising:
a first circuit pattern layer disposed between an upper surface of the first insulating layer and a lower surface of the second insulating layer,
wherein the first circuit pattern layer includes a first pad disposed in a first region of the first insulating layer vertically overlapping a lower surface of the cavity.

7. The circuit board of claim 6, wherein the first circuit pattern layer includes a second pad spaced apart from the first pad and vertically overlapping the inner wall of the cavity.

8. The circuit board of claim 7, wherein a thickness of the first pad is greater than that of the second pad.

9. The circuit board of claim 7, wherein the first circuit pattern layer includes a first metal layer disposed on an upper surface of the first insulating layer, and a second metal layer disposed on the first metal layer,
wherein the first pad includes both the first and second metal layers, and
wherein the second pad includes only the first metal layer.

10. The circuit board of claim 1, wherein the second insulating layer includes a recessed part formed at an inner wall of the cavity adjacent to an upper surface of the first insulating layer and concave in the inner direction of the second insulating layer, and
wherein at least a portion of the recessed part vertically overlaps an inner wall of the cavity.
